# EUROPEAN PATENT APPLICATION

(11) **EP 4 648 051 A1**
(43) Date of publication of application: **12.11.2025**
(21) Application number: 25171603.1
(22) Date of filing: 22.04.2025
(51) Int. Cl.: G11C 5/02, G11C 11/4097, G11C 8/08, G11C 8/14, G11C 11/408, G11C 7/18, G11C 5/06

(54) **SEMICONDUCTOR MEMORY DEVICE**

(30) Priority: 07.05.2024 KR 20240059883
(71) Applicant: Samsung Electronics Co., Ltd., Suwon-si, Gyeonggi-do 16677 (KR)
(72) Inventor: KIM, Yujin, 16677 Suwon-si, Gyeonggi-do (KR); LEE, Kyuseok, 16677 Suwon-si, Gyeonggi-do (KR); HAN, Jinwoo, 16677 Suwon-si, Gyeonggi-do (KR); OH, Gyuhwan, 16677 Suwon-si, Gyeonggi-do (KR); YOO, Bowon, 16677 Suwon-si, Gyeonggi-do (KR)
(74) Representative: Kuhnen & Wacker Patent- und Rechtsanwaltsbüro PartG mbB

(57) **Abstract**

A semiconductor memory device (1) including a substrate including a first stacked region, a second stacked region, and a pad region, the pad region being between the first stacked region and the second stacked region in a first horizontal direction (X), a plurality of word lines (WL) extending from the pad region toward each of the first stacked region and the second stacked region in the first horizontal direction (X) and spaced apart from each other in a vertical direction (Z), a plurality of bit lines (BL) extending in the vertical direction (Z) and spaced apart from each other in the first horizontal direction (X) in each of the first stacked region and the second stacked region, and a plurality of memory cells (MC) interposed between the plurality of word lines (WL) and the plurality of bit lines (BL) in each of the first and second stacked regions may be provided.

## Description

### BACKGROUND

The inventive concepts relate to semiconductor memory devices, and more specifically, to three-dimensional semiconductor memory devices including a plurality of memory cells arranged three-dimensionally.

As electronic products become more compact, multi-functional, and high-performance, high-capacity semiconductor memory devices are required. To this end, increased integration is required. Because the degree of integration of a conventional semiconductor memory device including a plurality of memory cells arranged two-dimensionally is mainly determined by an area occupied by a unit memory cell, the degree of integration of two-dimensional semiconductor memory devices has been increased but is still limited. Accordingly, a three-dimensional semiconductor memory device with increased memory capacity by stacking memory cells in a vertical direction on a substrate and including a plurality of memory cells arranged three-dimensionally has been proposed.

### SUMMARY

Some example embodiments of the inventive concepts provide three-dimensional semiconductor memory devices with increased integration.

According to an example embodiment of the inventive concepts, a semiconductor memory device includes a substrate including a first stacked region, a second stacked region, and a pad region, the pad region between the first stacked region and the second stacked region in a first horizontal direction, a plurality of word lines extending from the pad region toward each of the first stacked region and the second stacked region in the first horizontal direction, the plurality of word lines spaced apart from each other in a vertical direction, a plurality of bit lines extending in the vertical direction, the plurality of bit lines spaced apart from each other in the first horizontal direction in each of the first stacked region and the second stacked region, a plurality of memory cells interposed between the plurality of word lines and the plurality of bit lines in each of the first and second stacked regions, a word line contact connected to a corresponding one of the plurality of word lines at the pad region, and a sub-word line driver connected to the word line contact.

According to an example embodiment of the inventive concepts, a semiconductor memory device includes a lower structure and an upper structure stacked on the lower structure, the upper structure including a sub-word line driver, wherein the lower structure includes a substrate including a plurality of stacked regions and a plurality of pad regions, the plurality of stacked regions and the plurality of pad regions being alternate in a first horizontal direction, the plurality of stacked regions including a first stacked region and a second stacked region on both sides of one pad region of the plurality of pad regions in the first horizontal direction, a plurality of word lines each extending in the first horizontal direction from one of the plurality of pad regions toward each of the first stacked region and the second stacked region, the plurality of word lines spaced apart from each other in a vertical direction, a plurality of bit lines extending in the vertical direction, the plurality of bit lines spaced apart from each other in the first horizontal direction in each of the plurality of stacked regions, a plurality of memory cells interposed between the plurality of word lines and the plurality of bit lines in each of the plurality of stacked regions, and a word line contact connected to a corresponding one of the plurality of word lines in a corresponding one of the pad regions, wherein a portion of a specific word line of the plurality of word lines in the first stacked region and a portion of the specific word line in the second stacked region are electrically connected to the sub-word line driver through the word line contact that is connected to a portion of the specific word line in a corresponding one of the pad regions.

According to an example embodiment of the inventive concepts, a semiconductor memory device includes a lower structure and an upper structure stacked on the lower structure and including a sub-word line driver, wherein the lower structure includes a substrate including a first stacked region, a second stacked region, and a pad region, the pad region being between the first stacked region and the second stacked region, a plurality of word lines extending from the pad region toward each of the first stacked region and the second stacked region in a first horizontal direction, the plurality of word lines spaced apart from each other in a vertical direction, a plurality of bit lines extending in the vertical direction in each of the first stacked region and the second stacked region, the plurality of bit lines spaced apart from each other in the first horizontal direction, a plurality of memory cells being between the plurality of word lines and the plurality of bit lines in each of the first and second stacked regions, and a word line contact connected to a corresponding one of the plurality of word lines in the pad region, wherein a portion of a specific word line of the plurality of word lines in the first stacked region and a portion of the specific word line in the second stacked region are electrically connected to the sub-word line driver through the word line contact that is connected to a portion of the specific word line in the pad region, wherein each of the plurality of memory cells includes a cell transistor and an information storage element, and wherein the cell transistor includes a semiconductor pattern including a source region connected to a corresponding one of the plurality of bit lines, a channel region surrounded by the plurality of word lines, and a drain region connected to the information storage element, wherein the source region, the channel region, and the drain region are sequential in a second horizontal direction different from the first horizontal direction.

### BRIEF DESCRIPTION OF THE DRAWINGS

Some example embodiments will be more clearly understood from the following detailed description taken in conjunction with the accompanying drawings in which:
FIG. 1 is an equivalent circuit diagram showing a stacked cell array of a semiconductor memory device according to an example embodiment;
FIG. 2 is a block diagram illustrating a semiconductor memory device according to an example embodiment;
FIG. 3 is a perspective view showing a semiconductor memory device according to an example embodiment;
FIGS. 4A, 4B, and 4C are perspective and cross-sectional views showing a portion of the semiconductor memory device of FIG. 3;
FIG. 5 is a plan layout diagram showing a semiconductor memory device according to an example embodiment;
FIG. 6 is a plan layout diagram showing a semiconductor memory device according to an example embodiment;
FIG. 7 is an equivalent circuit diagram showing a stacked cell array of a semiconductor memory device according to an example embodiment;
FIG. 8 is a plan layout diagram showing a semiconductor memory device according to an example embodiment;
FIG. 9 is a block diagram illustrating a row decoder included in a semiconductor memory device according to an example embodiment;
FIG. 10 is a circuit diagram explaining a sub-word line driver circuit of FIG. 9;
FIGS. 11 to 13 are cross-sectional views showing a portion of a semiconductor memory device according to some example embodiments;
FIG. 14 is a perspective view showing a semiconductor memory device according to an example embodiment; and
FIG. 15 is a plan layout view showing a semiconductor memory device according to an example embodiment.

### DETAILED DESCRIPTION

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

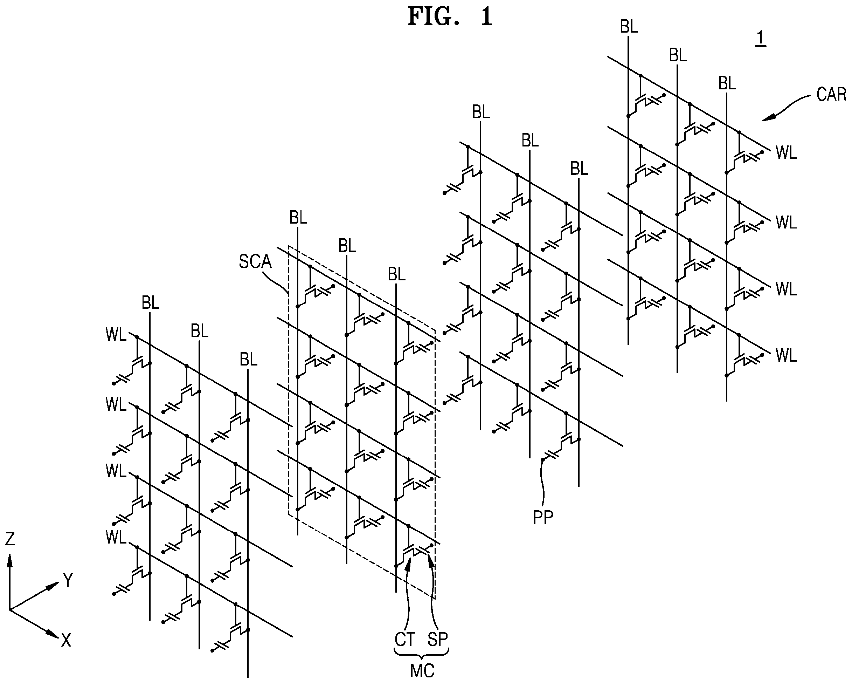

FIG. 1 is an equivalent circuit diagram showing a stacked cell array of a semiconductor memory device 1 according to an example embodiment.

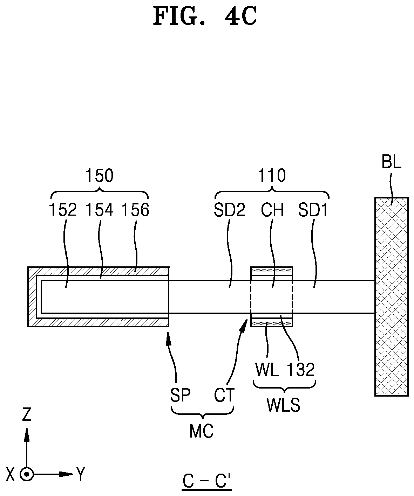

Referring to FIG. 1, a stack cell array structure CAR of the semiconductor memory device 1 according to an example embodiment of the inventive concepts includes a plurality of sub-cell arrays SCAs. The sub-cell array SCA may include a plurality of bit lines BL, a plurality of word lines WL, and a plurality of memory cells MC. Each of the plurality of memory cells MC includes a cell transistor CT and an information storage element SP. One cell transistor CT may be placed between one word line WL and one bit line BL. The information storage element SP may be connected to the cell transistor CT. The information storage element SP may be a memory element capable of storing data. The information storage element SP may include a memory element using a capacitor, a memory element using a magnetic tunnel junction pattern, or a memory element using a variable resistor including a phase change material. In some example embodiments, the memory cell MC may be a DRAM cell, the information storage element SP may be a capacitor, and a specific example of which will be described below with reference to FIG. 4C.

The word line WL may be a conductive pattern (e.g., a metal line) disposed on a substrate and spaced apart from the substrate. The plurality of word lines WL may extend in a first horizontal direction (X direction). The word lines WL within one sub-cell array SCA may be spaced apart from each other in a vertical direction (Z direction). The bit line BL may be a conductive pattern (e.g., a metal line) extending from the substrate in the vertical direction (Z direction). The bit lines BL within one sub-cell array SCA may be spaced apart from each other in the first horizontal direction (X direction).

In the stack cell array structure CAR, the plurality of word lines WL may extend in the first horizontal direction (X direction) and may be spaced apart from each other in the second horizontal direction (Y direction) and vertical direction (Z direction). In the stack cell array structure CAR, the plurality of bit lines BL may extend in the vertical direction (Z direction) and may be spaced apart from each other in the first horizontal direction (X direction) and the second horizontal direction (Y direction). A plurality of sub-cell arrays SCA may be arranged in the second horizontal direction (Y direction). The second horizontal direction (Y direction) may be perpendicular to the first horizontal direction (X direction).

A gate of the cell transistor CT may be connected to the word line WL, and a source region of the cell transistor CT may be connected to the bit line BL. The information storage element SP may be connected to a drain region of the cell transistor CT. In some example embodiments, the information storage element SP may be a capacitor including a first electrode, a second electrode, and a capacitor dielectric film interposed between the first electrode and the second electrode, and the first electrode of the capacitor may be connected to the drain region of the cell transistor CT, and the second electrode of the capacitor may be connected to a ground wire PP.

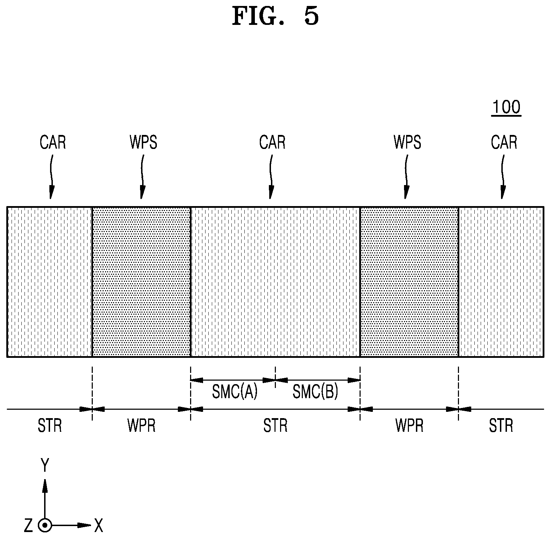

The stack cell array structure CAR of the semiconductor memory device 1 may include a plurality of memory cells MC arranged in rows and columns and spaced apart from each other in the first horizontal direction (X direction) and vertical direction (Z direction), respectively, a plurality of bit lines that are connected to the cell transistors CT of the memory cells MC arranged in the vertical direction (Z direction), extend in the vertical direction (Z direction) and spaced apart from each other in the first horizontal direction (X direction), and a plurality of sub-cell arrays SCA each including a plurality of word lines WL extending in the first horizontal direction (X direction) and spaced apart from each other in the vertical direction (Z direction). The plurality of sub-cell arrays SCA may be arranged in the second horizontal direction (Y direction). The semiconductor memory device 1 may include a plurality of stack cell array structures CAR, which will be described with reference to FIG. 5.

The first horizontal direction (X direction), the second horizontal direction (Y direction), and the vertical direction (Z direction) may be referred to as a first direction, a second direction, and a third direction, respectively. Alternatively, the first horizontal direction (X direction), the vertical direction (Z direction), and second horizontal direction (Y direction) may be referred to as a first direction, a second direction, and a third direction, respectively. The first direction, the second direction, and the third direction may be orthogonal to each other.

In some example embodiments, the source region and drain region of the cell transistor CT and the information storage element SP may be arranged in the second horizontal direction (Y direction) from the bit line BL connected to the source region of the cell transistor CT. The source and drain regions of the cell transistor CT that are connected to a corresponding one of the two adjacent bit lines BL in the second horizontal direction (Y direction) and the information storage element SP may be arranged in opposite directions. For example, (1) the source and drain regions of the cell transistor CT connected to one of the two bit lines BL that is adjacent in the second horizontal direction (Y direction) and (2) the information storage element SP may be sequentially arranged in the second horizontal direction (Y direction), and (1) the source and drain regions of the cell transistor CT connected to another one of the two bit lines BL and (2) the information storage element SP may be arranged in a direction opposite to the second horizontal direction (Y direction). For example, the plurality of bit lines BL may include a first bit line, a second bit line, a third bit line, and a fourth bit line arranged sequentially adjacent to each other in the second horizontal direction (Y direction), a memory cell MC may not be disposed between the first bit line and the second bit line, two memory cells MC may be disposed between the second bit line and the third bit line in the second horizontal direction (Y direction) at the same vertical level, and no memory cell MC may be disposed between the third bit line and the fourth bit line.

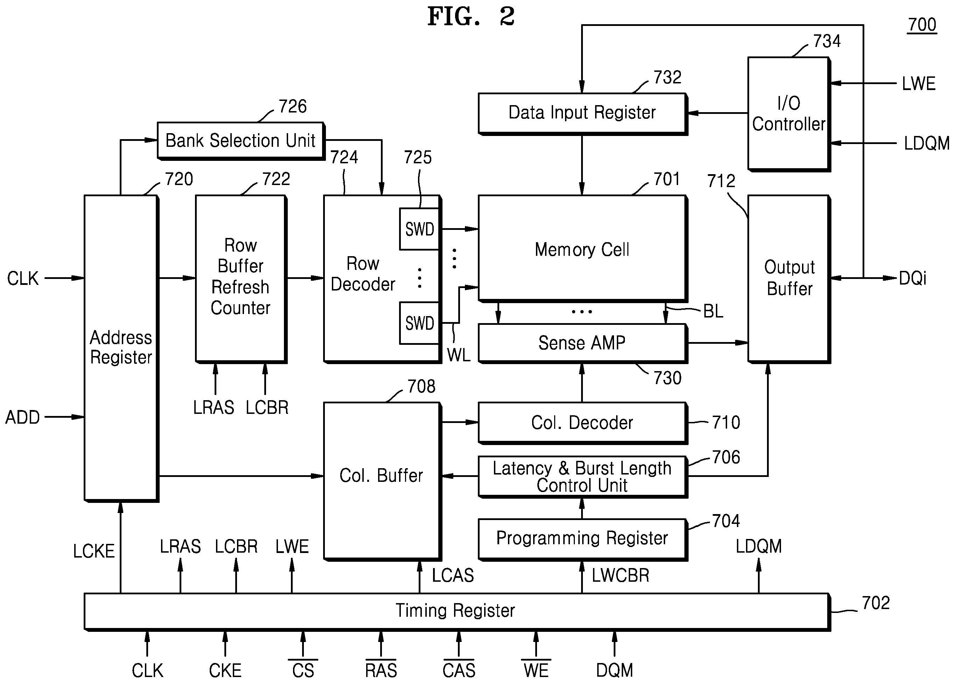

FIG. 2 is a block diagram illustrating a semiconductor memory device 700 according to an example embodiment of the present inventive concepts.

Referring to FIG. 2, the semiconductor memory device 700 includes a memory cell array 701 including a DRAM cell, which is a memory cell, and various circuit blocks for driving the DRAM cell. For example, a timing register 702 may be activated when a chip select signal CSB is changed from a deactivated level (e.g., logic high) to an activated level (e.g., logic low). The timing register 702 may receive a command signal, such as a clock signal CLK, a clock enable signal CKE, a chip select signal CSB, a row address strobe signal RASB, a column address strobe signal CASB, a write enable signal WEB, and a data input/output mask signal DQM from the outside, and may generate various internal command signals (LRAS, LCBR, LWE, LCAS, LWCBR, LDQM) for controlling the circuit blocks.

Some internal command signals generated from the timing register 702 are stored in a programming register 704. For example, latency information or burst length information related to data output may be stored in the programming register 704. Internal command signals stored in the programming register 704 may be provided to a latency/burst length control unit 706, and the latency/burst length control unit 706 may provide a control signal for controlling the latency or burst length of data output to a column decoder 710 or to an output buffer 712 through a column address buffer 708.

An address register 720 may receive a clock signal CLK and an address signal ADD from the outside. A row address signal may be provided to a row decoder 724 through a row buffer refresh counter 722. Additionally, a column address signal may be provided to the column decoder 710 through the column address buffer 708. The row buffer refresh counter 722 may further receive a refresh address signal generated from the refresh counter in response to a refresh command (LRAS, LCBR), and may provide either the row address signal or the refresh address signal to the row decoder 724. Additionally, the address register 720 may provide a bank signal for selecting a bank to a bank selection unit 726.

The row decoder 724 may decode the row address signal or refresh address signal input from the row buffer refresh counter 722. The row decoder 724 may include a plurality of sub-word line drivers 725. The sub-word line driver 725 may activate the word line WL of the memory cell array 701. The sub-word line driver 725 may be arranged in blocks at desired (or alternatively, predetermined) intervals within the row decoder 724 adjacent to the memory cell array 701. For example, the sub-word line driver 725 may be disposed perpendicular to the sense amplifier 730 and adjacent to one end of the memory cell array 701.

The column decoder 710 may decode a column address signal and perform a selection operation on a bit line of the memory cell array 701. As an example, a column selection line may be applied to the semiconductor memory device 700 to perform a selection operation through the column selection line.

The sense amplifier 730 may amplify data of a memory cell selected by the row decoder 724 and the column decoder 710 and provide the amplified data to the output buffer 712. Data to be written may be provided to the memory cell array 701 through the data input register 732, and the input/output controller 734 may control a data transfer operation through the data input register 732.

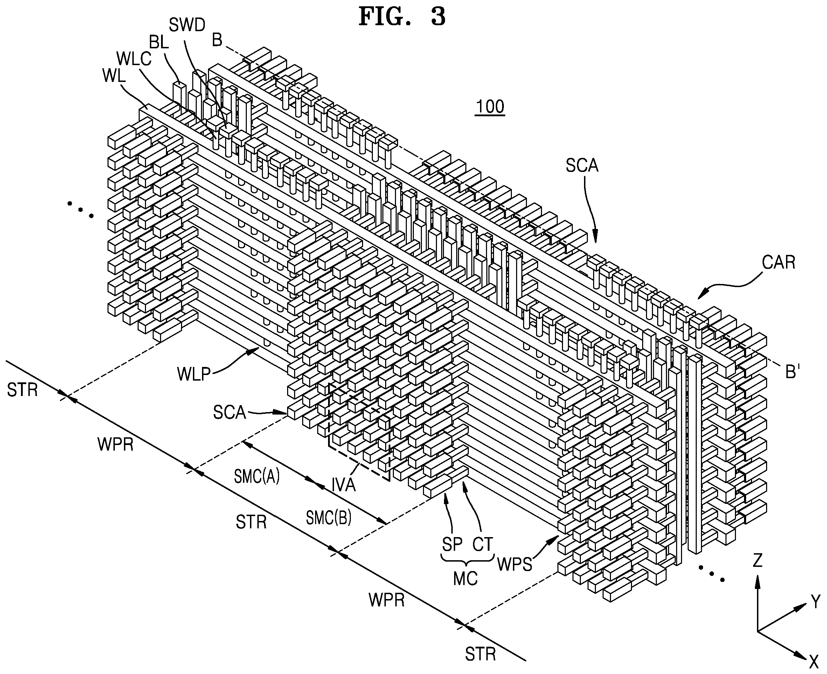

FIG. 3 is a perspective view showing a semiconductor memory device 100 according to an example embodiment.

Referring to FIG. 3, the semiconductor memory device 100 includes a plurality of stacked regions STR and a plurality of pad regions WPR. A stack cell array structure CAR may be located in each of the plurality of stacked regions STR, and a pad structure WPS may be located in each of the plurality of pad regions WPR. The plurality of stacked regions STR and the plurality of pad regions WPR may be alternately arranged in the first horizontal direction (X direction). For example, a pad region WPR may be disposed between a pair of stacked regions STR adjacent in the first horizontal direction (X direction), and a stacked region STR may be disposed between a pair of pad regions WPR adjacent in the first horizontal direction (X direction).

The stack cell array structure CAR may include a plurality of sub-cell arrays SCA. The plurality of sub-cell arrays SCA included in one stack cell array structure CAR may be arranged in the second horizontal direction (Y direction). The sub-cell array SCA may include a plurality of bit lines BL, a plurality of word lines WL, and a plurality of memory cells MC. Each of the plurality of memory cells MC includes a cell transistor CT and an information storage element SP.

The plurality of word lines WL may extend in the first horizontal direction (X direction). In the stack cell array structure CAR, the plurality of word lines WL may extend in the first horizontal direction (X direction) and may be spaced apart from each other in the second horizontal direction (Y direction) and the vertical direction (Z direction). Word lines WL within one sub-cell array SCA may be spaced apart from each other in the vertical direction (Z direction).

The bit lines BL may extend in the vertical direction (Z direction) from the substrate. In the stack cell array structure CAR, the plurality of bit lines BL may extend in the vertical direction (Z direction) and may be spaced apart from each other in the first horizontal direction (X direction) and the second horizontal direction (Y direction). The bit lines BL within one sub-cell array SCA may be spaced apart from each other in the first horizontal direction (X direction).

One cell transistor CT may be placed between one word line WL and one bit line BL. The information storage element SP may be connected to the cell transistor CT. The information storage element SP may be a memory element capable of storing data. A gate of the cell transistor CT may be connected to the word line WL, and a source region of the cell transistor CT may be connected to the bit line BL. The information storage element SP may be connected to a drain region of the cell transistor CT.

In some example embodiments, the source region and drain region of the cell transistor CT and the information storage element SP may be arranged in the second horizontal direction (Y direction) from the bit line BL connected to the source region of the cell transistor CT. The source and drain regions of the cell transistor CT connected to a corresponding one of the two adjacent bit lines BL in the second horizontal direction (Y direction) and the information storage element SP may be arranged in opposite directions to each other. For example, the source and drain regions of a cell transistor CT connected to one of the two bit lines BL adjacent in the second horizontal direction (Y direction) and an information storage element SP may be sequentially arranged in the second horizontal direction (Y direction), and the source and drain regions of another cell transistor CT connected to the other one of the two bit lines BL and an information storage element SP may be arranged in a direction opposite to the second horizontal direction (Y direction). For example, the plurality of bit lines BL may include a first bit line, a second bit line, a third bit line, and a fourth bit line arranged sequentially adjacent to each other in the second horizontal direction (Y direction), a memory cell MC may not be disposed between the first bit line and the second bit line, two memory cells MC may be disposed between the second bit line and the third bit line in a second horizontal direction (Y direction) at the same vertical level, and no memory cell MC may be disposed between the third bit line and the fourth bit line.

Each of the plurality of word lines WL may extend across the stacked region STR and the pad region WPR in the first horizontal direction (X direction). For example, each of the plurality of word lines WL may extend from the pad region WPR to each of a pair of adjacent stacked regions STR in the first horizontal direction (X direction). The pair of stacked regions STR adjacent to the pad region WPR in the first horizontal direction (X direction) from may be referred to as a first stacked region and a second stacked region. That is, each of the plurality of word lines (WL) may extend from one stacked region STR, that is, the first stacked region among the pair of stacked regions STR adjacent in the first horizontal direction (X direction) to another stacked region STR, that is, the second stacked region through the pad region WPR interposed between the pair of the stacked regions STR. In some example embodiments, each of the plurality of word lines WL may extend continuously along a plurality of stacked regions STR and a plurality of pad regions WPR arranged alternately in the first horizontal direction (X direction). An extended length of each of the plurality of word lines WL in the first horizontal direction (X direction) may be substantially the same. For example, the word lines WL that are spaced apart from each other in the vertical direction (Z direction) within the sub-cell array SCA may have the same extended length in the first horizontal direction (X direction).

Each of the plurality of word lines WL may include at least one word line pad WLP. The word line pad WLP may be a portion of the word line WL located in the pad region WPR. In some example embodiments, the number of word line pads WLP included in one word line WL may be equal to the number of pad regions WPR through which the one word line WL passes. For example, if each of the plurality of word lines WL passes through a plurality of pad regions WPR and extends in the first horizontal direction (X direction), each of the plurality of word lines WL may have a plurality of word line pads WLP.

A word line contact (WLC) may be connected to the word line pad WLP. The word line contact WLC may be in contact with the electrically connected word line WL among the word lines WL spaced apart in the vertical direction (Z direction) and may pass the word line WL located above the electrically connected word line WL. The word line contact WLC may not be electrically connected to the word line WL through which the word line contact WLC passes. For example, a contact insulating film may be interposed between the word line contact WLC and the word line WL through which the word line contact WLC passes. The word line contact WLC connected to the uppermost word line WL among the word lines WL spaced apart in the vertical direction (Z direction) may not pass the word lines WL. The word line contact WLC connected to the lowest word line WL among the word lines WL spaced apart in the vertical direction (Z direction) may pass the remaining word lines WL except for the lowest word line WL.

The word line pad WLP may be connected to a sub-word line driver SWD through the word line contact WLC. A lower end of the word line contact WLC may be in contact with the word line pad WLP. In FIG. 3, it is shown that an upper end of the word line contact WLC is in contact with the sub-word line driver SWD, but example embodiments of the present inventive concepts are not limited thereto. For example, wiring and/or contacts may be placed between the upper end of the word line contact WLC and the sub-word line driver SWD to electrically connect the word line contact WLC and the sub-word line driver SWD. The pad structure WPS may include portions of a plurality of word lines WL each extending from the stacked region STR to the pad region WPR and each including a word line pad WLP.

Each of the word lines WL included in the stack cell array structure CAR located in one stacked region STR may be connected to a pair of word line pads WLP included in a pair of pad structures WPS located in a pair of pad regions WPR adjacent to the one stacked region STR in the first horizontal direction (X direction). The pad region WPR disposed on one side of the stacked region STR in the first horizontal direction (X direction) may be referred to as a first pad region, and the pad region WPR disposed on the other side of the stacked region STR in the first horizontal direction (X direction) may be referred to as a second pad region.

The plurality of memory cells MC may include a first sub-memory cell group SMC(A) and a second sub-memory cell group SMC(B). The first sub-memory cell group SMC(A) may be adjacent to one pad structure WPS located in the first pad region among a pair of pad structures WPS adjacent to the stacked region STR, and the second sub-memory cell group SMC(B) may be adjacent to the other pad structure WPS located in the second pad region among the pair of pad structures WPS adjacent to the stacked region STR. Among the pair of pad structures WPS adjacent to the stacked region STR, one pad structure WPS adjacent to the first sub-memory cell group SMC(A) and located in the first pad region may be referred to as a first pad structure, and the other pad structure WPS adjacent to the second sub-memory cell group SMC(B) and located in the second pad region may be referred to as a second pad structure.

Each of the memory cells MC included in the first sub-memory cell group SMC(A) may be electrically connected to the sub-word line driver SWD connected to the first pad structure through the word line WL, and each of the memory cells MC included in the second sub-memory cell group SMC(B) may be electrically connected to the sub-word line driver SWD connected to the second pad structure through the word line WL. The sub-word line driver SWD connected to the first pad structure may be referred to as a first sub-word line driver, and the sub-word line driver SWD connected to the second pad structure may be referred to as a second sub-word line driver.

The first sub-word line driver may activate the word line WL connected to the memory cell MC included in the first sub-memory cell group SMC(A), thereby selecting a memory cell MC included in the first sub-memory cell group SMC(A) together with a corresponding bit line BL, and the second sub-word line driver may activate the word line WL connected to the memory cell MC included in the second sub-memory cell group SMC (B), thereby selecting a memory cell MC included in the second memory cell group SMC(B) together with a corresponding bit line BL.

Among a pair of stacked regions STR disposed on both ends of one pad region WPR in the first horizontal direction (X direction), the second sub-memory cell group SMC(B) located in one stacked region STR and adjacent to one pad region WPR and the first sub-memory cell group SMC(A) located in another stacked region STR and adjacent to one pad region WPR may be selected by the sub-word line drivers SWD connected to the word line contacts WLC located in the one pad region WPR.

In the semiconductor memory device 100 according to an example embodiment, the sub-word line drivers SWD connected to the word line contacts WLC located in a pad region WPR, which is disposed between a pair of adjacent stacked regions STR in the first horizontal direction (X direction), may select memory cells MC located in each of the pair of stacked regions (STR), and thus, the number of memory cells MC arranged in the first horizontal direction (X direction) within one stacked region STR may be increased, and an area occupied by the pad regions WPR within the semiconductor memory device 100 may be reduced. Therefore, the degree of integration of the semiconductor memory device 100 may be increased.

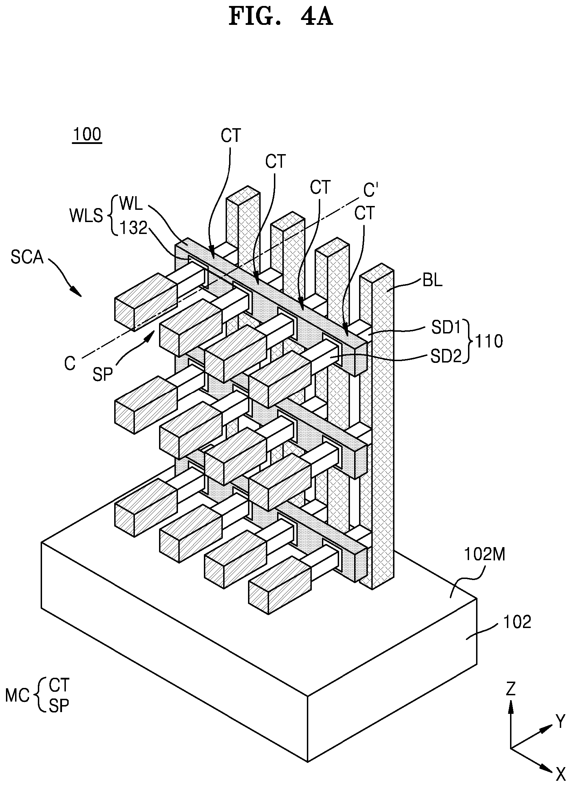

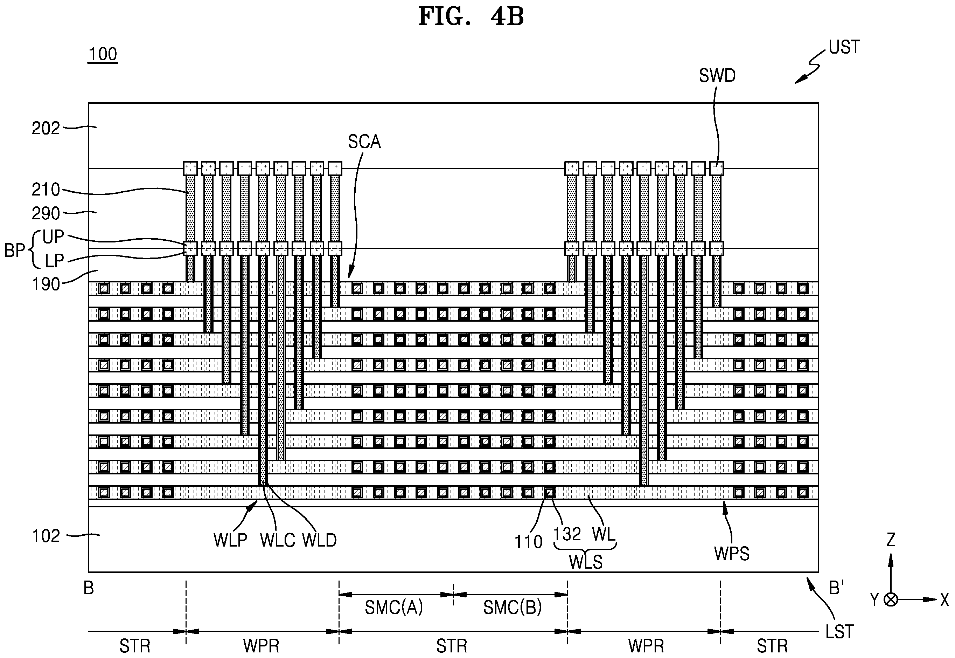

FIGS. 4A, 4B, and 4C are perspective and cross-sectional views showing a portion of the semiconductor memory device 100 of FIG. 3. Specifically, FIG. 4A is an enlarged perspective view of a portion IVA of FIG. 3, FIG. 4B is a cross-sectional view taken along line B-B' of FIG. 3, and FIG. 4C is a cross-sectional view taken along line C-C' of FIG. 4A.

Referring to FIGS. 4A to 4C together, the semiconductor memory device 100 includes a lower structure LST and an upper structure UST stacked on the lower structure LST. The lower structure LST and the upper structure UST may be referred to as a first structure and a second structure, or a cell structure and a peripheral circuit structure.

The lower structure LST includes a plurality of stacked regions STR and a plurality of pad regions WPR. The plurality of stacked regions STR and the plurality of pad regions WPR may be alternately arranged in the first horizontal direction (X direction). The pad region WPR disposed on one side of the stacked region STR in the first horizontal direction (X direction) may be referred to as a first pad region, and the pad region WPR disposed on the other side of the stacked region STR in the first horizontal direction (X direction) may be referred to as a second pad region. The lower structure LST includes a substrate 102, a sub-cell array SCA disposed in the stacked region STR, and a pad structure WPS disposed in the pad region WPR on the substrate 102. The pad structure WPS located in the first pad region may be referred to as a first pad structure, and the pad structure WPS located in the second pad region may be referred to as a second pad structure.

The sub-cell array SCA may include the substrate 102 , a plurality of word lines WL spaced apart from the substrate 102 and disposed on a main surface 102M of the substrate 102, a plurality of bit lines BL extending in the vertical direction (Z direction) from the main surface 102M of the substrate 102, a plurality of cell transistors CT disposed between the plurality of word lines WL and the plurality of bit lines BL, and a plurality of information storage elements SP connected to the plurality of cell transistors CT. The cell transistor CT and the information storage element SP may constitute the memory cell MC.

The substrate 102 may include, for example, silicon (Si), such as crystalline Si, polycrystalline Si, or amorphous Si. For example, the substrate 102 may include at least one compound semiconductor selected from a semiconductor element, such as germanium (Ge), silicon germanium (SiGe), silicon carbide (SiC), gallium arsenide (GaAs), indium arsenide (InAs), and indium phosphide (InP). In some example embodiments, the substrate 102 may include a silicon-on-insulator (SOI) substrate or a germanium-on-insulator (GeOI) substrate. For example, the substrate 102 may include a buried oxide layer. The substrate 102 may include a conductive region, for example, a well doped with an impurity, or a structure doped with an impurity.

The plurality of word lines WL may extend in the first horizontal direction (X direction) on the substrate 102 and may be spaced apart from each other in the vertical direction (Z direction). The plurality of bit lines BL may extend from the substrate 102 in the vertical direction (Z direction) and may be spaced apart from each other in the first horizontal direction (X direction).

One cell transistor CT may be disposed between one word line WL and one bit line BL. The information storage element SP may be connected to the cell transistor CT. The cell transistor CT and the information storage element SP may be sequentially arranged in the second horizontal direction (Y direction) from the bit line BL to which the cell transistor CT is connected.

The word line WL may be adjacent to a semiconductor pattern 110. In some example embodiments, the word line WL may surround the semiconductor pattern 110. A gate dielectric layer 132 may be interposed between the word line WL and the semiconductor pattern 110. The word line WL and the gate dielectric layer 132 may form a word line structure WLS. The semiconductor pattern 110 and the word line structure WLS may form a cell transistor CT.

The semiconductor pattern 110 may include a source region SD1, a drain region SD2, and a channel region CH interposed between the source region SD1 and the drain region SD2. The source region SD1 may be connected to the bit line BL, and the drain region SD2 may be connected to the information storage element SP. The source region SD1, the channel region CH, and the drain region SD2 may be sequentially arranged in the second horizontal direction (Y direction) from the bit line BL.

In some example embodiments, the semiconductor pattern 110 may include a material that has the same or similar etch characteristics as the substrate 102, or may include the same material. In some example embodiments, the semiconductor pattern 110 may include Si. In some example embodiments, the semiconductor pattern 110 may include a single crystal semiconductor material. For example, the semiconductor pattern 110 may include single crystal Si. In some other example embodiments, the semiconductor pattern 110 may include a 2D semiconductor material or an oxide semiconductor material. For example, the 2D semiconductor material may include MoS₂, WSe₂, Graphene, Carbon Nano Tube, or a combination thereof. For example, the oxide semiconductor material may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or any combination thereof. For example, the semiconductor pattern 110 may include a single layer or multiple layers of the oxide semiconductor material. In some example embodiments, the semiconductor pattern 110 may include a material having a band gap energy greater than that of silicon. For example, the semiconductor pattern 110 may include a material having a band gap energy in a range from about 1.5 eV to about 5.6 eV. For example, if each of the semiconductor patterns 110 has a bandgap energy in a range from about 2.0 eV to about 4.0 eV, the semiconductor patterns 110 may include a material that may have optimal or relatively improved channel performance.

A first impurity having a first conductivity type may be implanted into the source region SD1 and the drain region SD2 of the semiconductor pattern 110, and a second conductivity type different from the first conductivity type may be implanted into the channel region CH. In some example embodiments, the first conductivity type may be n-type, and the second conductivity type may be p-type.

In some example embodiments, the word line WL may include a conductive barrier film covering the gate dielectric layer 132 and a conductive filling layer covering the conductive barrier film. The conductive barrier film may include, for example, metal, conductive metal nitride, conductive metal silicide, or a combination thereof. For example, the conductive barrier film may include TiN. The conductive filling layer may include, for example, doped silicon, Ru, RuO, Pt, PtO, Ir, IrO, SrRuO (SRO), (Ba,Sr)RuO (BSRO), CaRuO (CRO), BaRuO, La(Sr ,Co)O, Ti, TiN, W, WN, Ta, TaN, TiAlN, TiSiN, TaAlN, TaSiN, or any combination thereof. In some example embodiments, the conductive filling layer may include W.

The gate dielectric layer 132 may include at least one selected from silicon oxide, a high-k dielectric material having a higher dielectric constant than silicon oxide, and a ferroelectric material. In some example embodiments, the gate dielectric layer 132 may have a stacked structure of a first dielectric film including silicon oxide and a second dielectric film including at least one material selected from a high-k dielectric material and a ferroelectric material. For example, the high-k dielectric material and the ferroelectric material may be at least one material selected from hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium Titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO).

The bit line BL may include a conductive barrier film in contact with one end of the semiconductor pattern 110, for example, the source region SD1, and a conductive filling layer covering the conductive barrier film. The conductive barrier film may include, for example, metal, conductive metal nitride, conductive metal silicide, or any combination thereof. For example, the conductive barrier film may include TiN. The conductive filling layer may include, for example, doped silicon, Ru, RuO, Pt, PtO, Ir, IrO, SrRuO (SRO), (Ba,Sr)RuO (BSRO), CaRuO (CRO), BaRuO, La(Sr,Co)O, Ti, TiN, W, WN, Ta, TaN, TiAlN, TiSiN, TaAlN, TaSiN, or any combination thereof. In some example embodiments, the conductive filling layer may include W.

In some example embodiments, the information storage element SP may be a capacitor 150 including a first electrode 152, a second electrode 156, and a capacitor dielectric film 154 disposed between the first electrode 152 and the second electrode 156. The capacitor 150 may include the first electrode 152 connected to the drain region of the semiconductor pattern 110 and extending in the second horizontal direction (Y direction), the capacitor dielectric film 154 covering the first electrode 152, and the second electrode 156 covering the capacitor dielectric film 154. The second electrode 156 may be connected to the ground wire PP shown in FIG. 1 or may be a part of the ground wire PP. The first electrode 152 and the second electrode 156 may be referred to as a lower electrode and an upper electrode. The capacitor dielectric film 154 may be disposed between the first electrode 152 and the second electrode 156.

The first electrode 152 may include metal, conductive metal nitride, conductive metal silicide, or any combination thereof. In some example embodiments, the first electrode 152 may include a high-melting point metal film, such as cobalt, titanium, nickel, tungsten, and molybdenum. For example, the first electrode 152 may include a metal nitride film, such as titanium nitride, titanium silicon nitride, titanium aluminum nitride, tantalum nitride, tantalum silicon nitride, tantalum aluminum nitride, and tungsten nitride.

The capacitor dielectric film 154 may include at least one selected from a high-k dielectric material having a higher dielectric constant than silicon oxide and a ferroelectric material. For example, the capacitor dielectric film 154 may include at least one of a metal oxide or perovskite structure dielectric material. In some example embodiments, the capacitor dielectric film 154 may include at least one selected from HfO, HfSiO, HfON, HfSiON, LaO, LaAlO, ZrO, ZrSiO, ZrON, ZrSiON, TaO, TiO, BaSrTiO, BaTiO, PZT, STB, BFO, SrTiO, YO, AlO, and PbScTaO.

The second electrode 156 may include, for example, doped silicon, Ru, RuO, Pt, PtO, Ir, IrO, SrRuO (SRO), (Ba,Sr)RuO (BSRO), CaRuO (CRO), BaRuO, La(Sr ,Co)O, Ti, TiN, W, WN, Ta, TaN, TiAlN, TiSiN, TaAlN, TaSiN, or any combination thereof. In some example embodiments, the second electrode 156 may include W. In FIGS. 3 to 4C, the plurality of information storage elements SP are spaced apart from each other, but example embodiments of the present inventive concepts are not limited thereto. In some example embodiments, if the plurality of information storage elements SP are a plurality of capacitors 150, the plurality of second electrodes 156 of the plurality of capacitors 150 included in the sub-cell array SCA may be connected to each other to form an integrated unit. In some example embodiments, if the plurality of information storage elements SP are a plurality of capacitors 150, and if a plurality of capacitors 150 included in each pair of the sub-cell arrays SCA adjacent in the second horizontal direction (Y direction) face each other and are adjacent to each other, the plurality of second electrodes 156 of the plurality of capacitors 150 included in each pair of sub-cell arrays SCA may be connected to each other to form an integrated unit.

Each of the plurality of word lines WL may extend across the stacked region STR and the pad region WPR in the first horizontal direction (X direction). For example, each of the plurality of word lines WL may extend from the pad region WPR to each of the pair of adjacent stacked regions STR in the first horizontal direction (X direction). That is, each of the plurality of word lines WL may extend from one stacked region STR among a pair of stacked regions adjacent in the first horizontal direction (X direction) to the other one stacked region STR through the pad region WPR disposed between the pair of stacked regions STR. In some example embodiments, each of the plurality of word lines WL may extend continuously along a plurality of stacked regions STR and a plurality of pad regions WPR arranged alternately in the first horizontal direction (X direction). An extension length of each of the plurality of word lines WL in the first horizontal direction (X direction) may be substantially the same.

Each of the plurality of word lines WL may include at least one word line pad WLP. The word line pad WLP may be a portion of the word line WL located in the pad region WPR. In some example embodiments, the number of word line pads WLP included in one word line WL may be equal to the number of pad regions WPR through which the one word line WL passes. For example, if each of the plurality of word lines WL passes through a plurality of pad regions WPR and extends in the first horizontal direction (X direction), each of the plurality of word lines WL may include a plurality of word line pads WLP. A word line contact WLC may be connected to a word line pad WLP. The word line contact WLC may include metal, conductive metal nitride, conductive metal silicide, or any combination thereof. A first bonding pad unit LP may be connected to a top of the word line contact WLC.

A first insulating structure 190 may cover the sub-cell array SCA and the pad structure WPS on the substrate 102. The first insulating structure 190 may surround a plurality of word lines WL, a plurality of word line contacts WLC, and a plurality of first bonding pad units LP. An upper surface of the first bonding pad unit LP and an upper surface of the first insulating structure 190 may be disposed on the same plane.

In example embodiments, the first insulating structure 190 may include an insulating material that may include silicon oxide, silicon nitride, a low-k material, or any combination thereof. The low-k (e.g., low-dielectric) material may be a material having a lower dielectric constant than silicon oxide and may include, for example, phosphosilicate glass (PSG), borophosphosilicate glass (BPSG), fluorosilicate glass (FSG), organosilicate glass (OSG), spin-on-glass (SOG), spin-on-polymer, or any combination thereof. In some example embodiments, the first insulating structure 190 may include an Ultra Low k (ULK) film having an ultra-low dielectric constant K in a range from about 2.2 to about 2.4. The ULK film may include SiOC or SiCOH. The first bonding pad unit LP may include a conductive material that may include copper (Cu), gold (Au), silver (Ag), aluminum (Al), tungsten (W), titanium (Ti), tantalum (Ta), or any combination thereof.

The upper structure UST may include a peripheral circuit board 202, a second insulating structure 290 covering a lower surface of the peripheral circuit board 202, a plurality of sub-word line drivers SWD disposed between the peripheral circuit board 202 and the second insulating structure 290, a plurality of interconnector structures 210 connected to the plurality of sub-word line drivers SWD, and a plurality of second bonding pad units UP connected to lower surfaces of the plurality of interconnector structures 210. The second insulating structure 290 may surround the plurality of interconnector structures 210 and the plurality of second bonding pad units UP. Lower surfaces of the second bonding pad units UP and a lower surface of the second insulating structure 290 may be disposed on the same plane. The plurality of interconnector structures 210 may electrically connect the sub-word line driver SWD to the plurality of second bonding pad units UP. Each of the peripheral circuit board 202, the second bonding pad unit UP, and the second insulating structure 290 may include the same materials as or similar to the materials of the substrate 102, the first bonding pad unit LP, and the first insulating structure 190, respectively. In FIG. 4B, each of the plurality of interconnector structures 210 is shown as consisting of only contacts, but example embodiments are not limited thereto. For example, each of the plurality of interconnector structures 210 may include at least one wiring layer and at least one contact.

The upper structure UST may be bonded to the lower structure LST by contacting the second insulating structure 290 and the first insulating structure 190 and contacting the plurality of second bonding pad units UP and the plurality of first bonding pad units LP. In some example embodiments, the lower structure LST and the upper structure UST may be bonded to each other using a metal-oxide hybrid bonding method, and accordingly, a plurality of word lines WL included in the lower structure LST may be electrically connected to a plurality of sub-word line drivers SWD included in the upper structure UST. For example, the plurality of first bonding pad units LP and the plurality of second bonding pad units UP corresponding to each other may be a plurality of bonding pads BP that undergo diffusion bonding such that they expand thermally to contact each other and then are united to form one body through diffusion of metal atoms therein. For example, the first insulating structure 190 and the second insulating structure 290 may be bonded to each other by forming a covalent bond. Among the plurality of bonding pads BP, a portion surrounded by the first insulating structure 190 may be the first bonding pad unit LP, and a portion surrounded by the second insulating structure 290 may be the second bonding pad unit UP.

One word line WL may include a plurality of word line pads WLP corresponding to a plurality of pad regions WPR through which the one word line WL passes. A word line contact WLC may be connected to the word line pad WLP. The word line contact WLC may be in contact with the electrically connected word line WL among the word lines WL spaced apart in the vertical direction (Z direction) and may penetrate one or more word lines WL located above the one word line WL that is electrically connected to the word line contact WLC. The word line contact WLC may not be electrically connected to the word lines WL through which the word line contact WLC passes. For example, a contact insulating film WLD may be disposed between the word line contact WLC and the word lines WL through which the word line contact WLC passes. The word line contact WLC connected to the uppermost word line WL among the word lines WL spaced apart in the vertical direction (Z direction) may not penetrate any word lines WL. The word line contact WLC connected to the lowest word line WL among the word lines WL spaced apart in the vertical direction (Z direction) may penetrate the remaining word lines WL except for the lowest word line WL.

In some example embodiments, one word line contact WLC may be connected to a corresponding one of the word lines WL included in one sub-cell array SCA in one pad region WPR, but example embodiments of the present inventive concepts are not limited thereto. For example, the number of word line contacts WLC connected to corresponding ones of the word lines WL included in one sub-cell array SCA in one pad region WPR may be an integer of 1 or more. If word line contacts WLC are connected to corresponding ones of the word lines WL included in one sub-cell array SCA in one pad region WPR, extension lengths of the word line contacts WLC disposed in one pad region WPR in the vertical direction (Z direction) may be different from each other. Among the word line contacts WLC disposed in one pad region WPR, an extension length in the vertical direction (Z direction) of one word line contact WLC located relatively far from a pair of stacked regions STR adjacent in the first horizontal direction (X direction) may be greater than an extension length in the vertical direction (Z direction) of another word line contact WLC located relatively close to the pair of stacked regions STR. For example, in an X-Z plane, a bottom of each word line contact WLC disposed in one pad region WPR may have a V shape.

The word line pad WLP may be connected to the sub-word line driver SWD through the word line contact WLC. The bottom of the word line contact WLC may be in contact with the word line pad WLP. The word line WL may be connected to the plurality of sub-word line drivers SWD through the word line contact WLC, the bonding pad BP, and the interconnector structure 210 connected to a corresponding one of the plurality of word line pads WLP.

The plurality of memory cells MC may include a first sub-memory cell group SMC(A) and a second sub-memory cell group SMC(B). The first sub-memory cell group SMC(A) may be adjacent to one pad structure WPS located in the first pad region among a pair of pad structures WPS adjacent to the stacked region STR, the second sub-memory cell group SMC(B) may be adjacent to the other pad structure WPS located in the second pad region among the pair of pad structures WPS adjacent to the stacked region STR. Each of the memory cells MC included in the first sub-memory cell group SMC(A) may be electrically connected to the sub-word line driver SWD connected to the first pad structure through a corresponding word line WL and each of the memory cells MC included in the second sub-memory cell group SMC(B) may be electrically connected to the sub-word line driver SWD connected to the second pad structure through a corresponding word line WL. The first sub-word line driver may activate a word line WL connected to the memory cell MC included in the first sub-memory cell group SMC(A), and thus, may select the memory cell MC included in the first sub-memory cell group SMC(A) together with a corresponding bit line BL, and the second sub-word line driver may activate a word line WL connected to the memory cell MC included in the second sub-memory cell group SMC (B), thereby selecting the memory cell MC included in the second memory cell group SMC(B) together with the corresponding bit line BL.

Among a pair of stacked regions STR disposed on both ends of one pad region WPR in the first horizontal direction (X direction), the second sub-memory cell group SMC(B) located in one stacked region STR and adjacent to one pad region WPR and the first sub-memory cell group SMC(A) located in another stacked region STR and adjacent to one pad region WPR may be selected by the sub-word line drivers SWD connected to the word line contacts WLC located in the one pad region WPR.

In the semiconductor memory device 100 according to an example embodiment, the sub-word line drivers SWD connected to the word line contacts WLC located in a pad region WPR, which is disposed between a pair of adjacent stacked regions STR in the first horizontal direction (X direction), may select memory cells MC located in each of the pair of stacked regions (STR), and thus, the number of memory cells MC arranged in the first horizontal direction (X direction) within one stacked region STR may be increased, and an area occupied by the pad regions WPR within the semiconductor memory device 100 may be reduced. Therefore, the degree of integration of the semiconductor memory device 100 may be increased.

FIG. 5 is a plan layout diagram showing a semiconductor memory device 100 according to an example embodiment.

Referring to FIG. 5, the semiconductor memory device 100 includes a plurality of stacked regions STR and a plurality of pad regions WPR. A stacked cell array structure CAR may be located in each of the plurality of stacked regions STR, and a pad structure WPS may be located in each of the pad regions WPR. The plurality of stacked regions STR and the plurality of pad regions WPR may be alternately arranged in the first horizontal direction (X direction). The plurality of stacked regions STR may be arranged to be spaced apart from each other in the first horizontal direction (X direction), and the plurality of pad regions WPR may be arranged to be spaced apart from each other in the first horizontal direction (X direction). For example, a pad region WPR may be disposed between a pair of stacked regions STR adjacent in the first horizontal direction (X direction), and a stacked region STR may be disposed between a pair of pad regions WPR adjacent in the first horizontal direction (X direction).

The stacked cell array structure CAR may include a first sub-memory cell group SMC(A) and a second sub-memory cell group SMC(B). The first sub-memory cell group SMC(A) may be adj acent to one pad region WPR of a pair of pad regions WPR adj acent to the stacked region STR in the first horizontal direction (X direction) and the second sub-memory cell group SMC(B) may be adjacent to the other pad region WPR of the pair of pad regions WPR adjacent to the stacked region STR in the first horizontal direction (X direction). The first sub-memory cell group SMC(A) may be connected to the pad structure WPS located in one adjacent pad region WPR, and the second sub-memory cell group SMC(B) may be connected to the pad structure WPS located in another adjacent pad region WPR.

In the semiconductor memory device 100 according to an example embodiment, because a plurality of stacked regions STR and a plurality of pad regions WPR are alternately arranged in the first horizontal direction (X direction), a horizontal width of the stacked region STR may increase and a horizontal width of the pad region WPR may decrease in the first horizontal direction (X direction). Therefore, the degree of integration of the semiconductor memory device 100 may be increased.

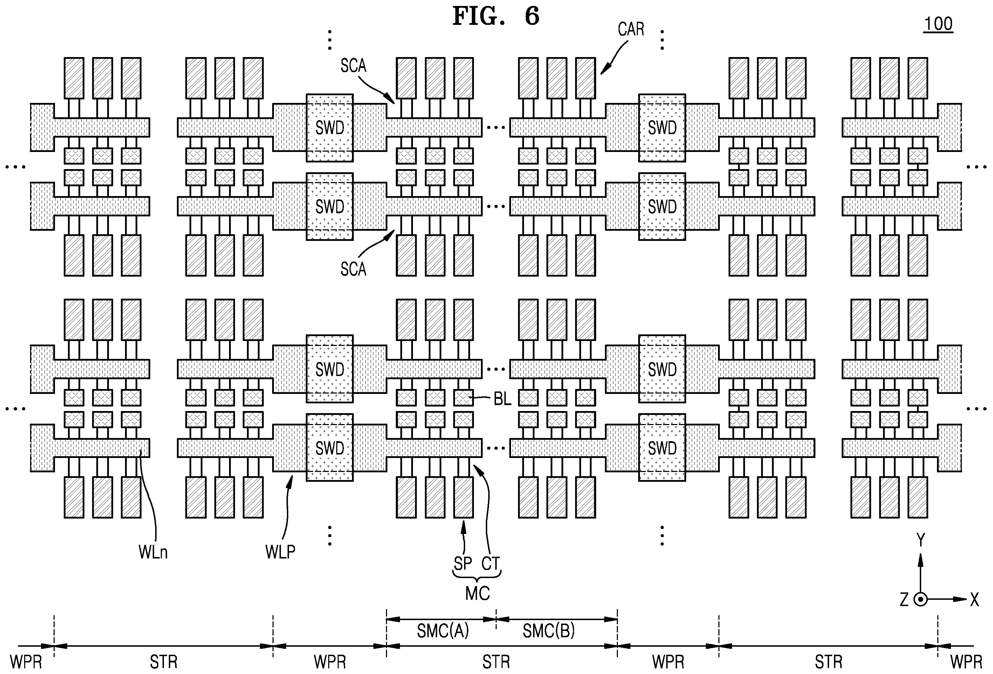

FIG. 6 is a plan layout diagram showing a semiconductor memory device 100 according to an example embodiment.

Referring to FIG. 6, the semiconductor memory device 100 includes a plurality of stacked regions STR and a plurality of pad regions WPR. A stacked cell array structure CAR may be positioned in the stacked region STR, and a pad structure WPS may be located in the pad region WPR. The stacked cell array structure CAR may include a plurality of sub-cell arrays SCAs. The plurality of stacked regions STR and the plurality of pad regions WPR may be alternately arranged in the first horizontal direction (X direction). The stacked cell array structure CAR may include a first sub-memory cell group SMC(A) adjacent to one pad region WPR of a pair of pad regions WPR adjacent to the stacked region STR and a second sub-memory cell group SMC(B) adjacent to the other pad region WPR of the pair of pad regions WPR.

A sub-cell array SCA may include a plurality of word lines WL, a plurality of bit lines BL, and a plurality of memory cells MC disposed between the plurality of word lines WL and the plurality of bit lines BL and each including a cell transistor CT and an information storage element SP.

The plurality of word lines WL may extend in the first horizontal direction (X direction) and may be spaced apart from each other in the vertical direction (Z direction). At least two sub-word line drivers SWD may be connected to the plurality of word lines WL. In some example embodiments, a plurality of sub-word line drivers SWD corresponding to the plurality of pad regions WPR may be connected to corresponding ones of the plurality of word lines WL, respectively.

The memory cells MC included in the first sub-memory cell group SMC(A) may be selected by the sub-word line drivers SWD connected to the word lines WL through one pad region WPR adjacent in the first horizontal direction (X direction), and the memory cells MC included in the second sub-memory cell group SMC(B) may be selected by the sub-word line drivers SWD connected to the word lines WL through another pad region WPR adjacent in the first horizontal direction (X direction).

In the semiconductor memory device 100 according to an example embodiment, because memory cells MC included in two or more stacked cell array structures may be configured into one stacked cell array structure CAR, and the memory cells MC included in two stacked cell array structures CAR may be selected through one pad region WPR, the degree of integration of the semiconductor memory device 100 may be increased.

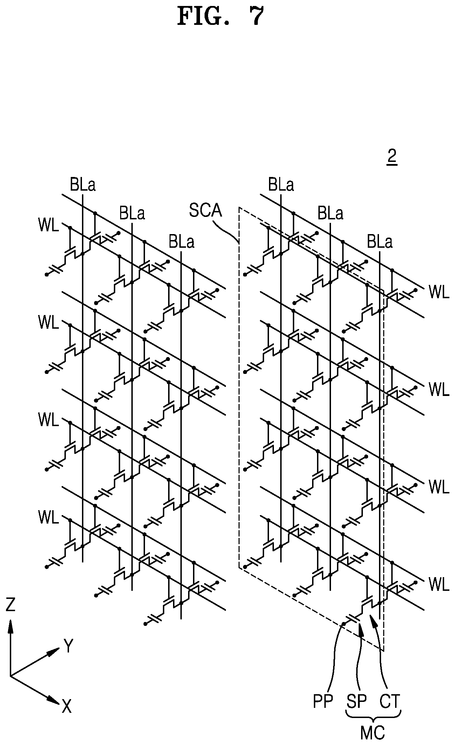

FIG. 7 is an equivalent circuit diagram showing a stacked cell array of a semiconductor memory device 2 according to an example embodiment.

Referring to FIG. 7, the stacked cell array structure CAR of the semiconductor memory device 2 according to this example embodiment includes a plurality of sub-cell arrays SCAs. The sub-cell array SCA may include a plurality of bit lines BLa, a plurality of word lines WL, and a plurality of memory cells MC. Each of the plurality of memory cells MC includes a cell transistor CT and an information storage element SP. One cell transistor CT may be disposed between one word line WL and one bit line BLa.

The plurality of word lines WL may extend in the first horizontal direction (X direction). Word lines WL within one sub-cell array SCA may be spaced apart from each other in the vertical direction (Z direction). The bit line BLa may extend from the substrate in the vertical direction (Z direction). The bit lines BLa within one sub-cell array SCA may be spaced apart from each other in the first horizontal direction (X direction). A gate of the cell transistor CT may be connected to the word line WL, and a source region of the cell transistor CT may be connected to the bit line BLa. The information storage element SP may be connected to the drain region of the cell transistor CT.

Two sub-cell arrays SCA adjacent to each other in the second horizontal direction (Y direction) may share the bit lines BLa. Source regions of the cell transistors CT included in each of the two sub-cell arrays SCA may be connected to the bit lines BLa that are shared by the two sub-cell arrays SCA. The source region and the drain region of the cell transistor CT of each of the two sub-cell arrays SCA and the information storage element SP may be arranged in opposite directions from each of the bit lines BLa shared by the two sub-cell arrays SCA. For example, the source region and the drain region of the cell transistor CT of one sub-cell array SCA connected to one bit line BLa shared by two sub-cell arrays SCA and the information storage element SP may be sequentially arranged in the second horizontal direction (Y direction), and the source region and the drain region of the cell transistor CT of another sub-cell array SCA connected to the one bit line and the information storage element SP may be arranged in a direction opposite to the second horizontal direction (Y direction).

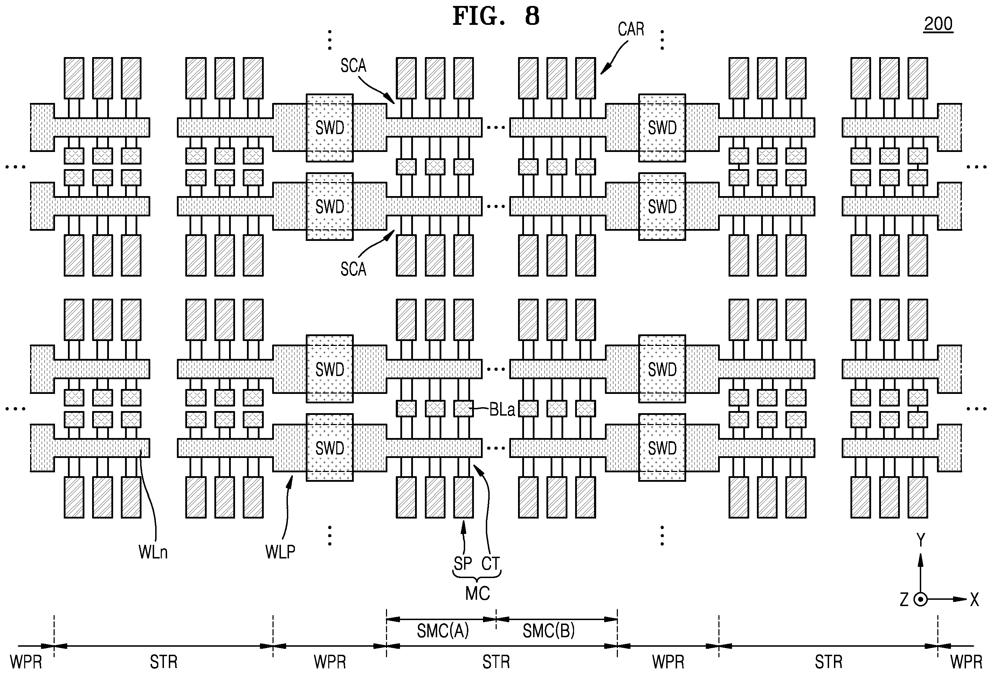

FIG. 8 is a plan layout diagram showing a semiconductor memory device 200 according to an example embodiment.

Referring to FIG. 8, the semiconductor memory device 200 includes a plurality of stacked regions STR and a plurality of pad regions WPR. A stacked cell array structure CAR may be positioned in the stacked region STR, and a pad structure WPS may be positioned in the pad region WPR. The stacked cell array structure CAR may include a plurality of sub-cell arrays SCAs. The plurality of stacked regions STR and the plurality of pad regions WPR may be alternately arranged in the first horizontal direction (X direction). The stacked cell array structure CAR may include a first sub-memory cell group SMC(A) adjacent to one pad region WPR among a pair of pad regions WPR adjacent to the stacked region STR and a second sub-memory cell group SMC(B) adjacent to the other pad region WPR among the pair of pad regions WPR.

The sub-cell array SCA may include a plurality of word lines WL, a plurality of bit lines BLa, and a plurality of memory cells MC disposed between the plurality of word lines WL and the plurality of bit lines BLa. Each of the plurality of memory cells MC includes a cell transistor CT and an information storage element SP. Two sub-cell arrays SCA adjacent to each other in the second horizontal direction (Y direction) may share bit lines BLa. Source regions of cell transistors CT included in each of the two sub-cell arrays SCA may be connected to the bit lines BLa shared by the two sub-cell arrays SCA.

The plurality of word lines WL may extend in the first horizontal direction (X direction) and may be spaced apart from each other in the vertical direction (Z direction). At least two sub-word line drivers SWD may be connected to corresponding ones of the plurality of word lines WL, respectively. In some example embodiments, a plurality of sub-word line drivers SWD corresponding to a plurality of pad regions WPR may be connected to corresponding ones of the plurality of word lines WL, respectively.

The memory cells MC included in the first sub-memory cell group SMC(A) may be selected by the sub-word line drivers SWD connected to the word lines WL through one pad region WPR adjacent in the first horizontal direction (X direction), and the memory cells MC included in the second sub-memory cell group SMC(B) may be selected by the sub-word line drivers SWD connected to the word lines WL through another pad region WPR adjacent in the first horizontal direction (X direction).

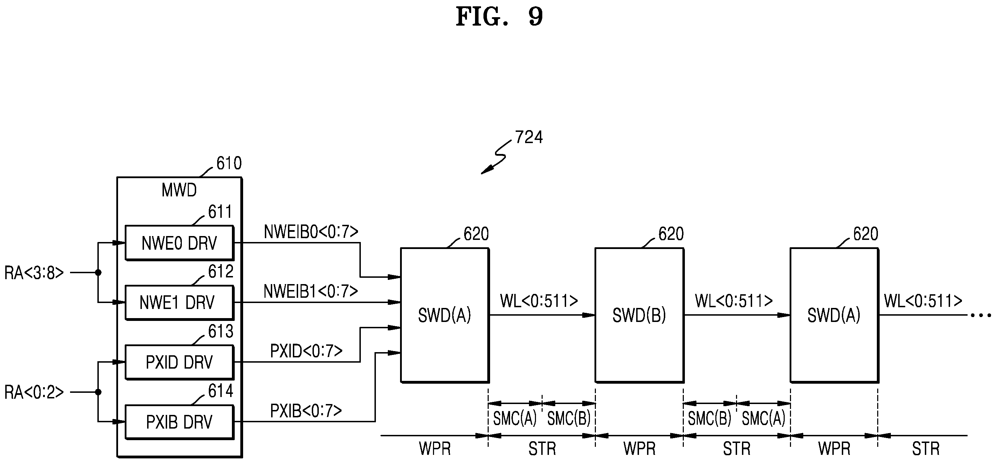

FIG. 9 is a block diagram illustrating a row decoder 724 included in a semiconductor memory device according to an example embodiment. Specifically, FIG. 9 is a block diagram for explaining the row decoder 724 of FIG. 2.

Referring to FIG. 9, the row decoder 724 may select a word line WL corresponding to a row address RA. The row decoder 724 may be placed in the upper structure UST, as shown in FIG. 4B. In the present example embodiment, it is described that the row decoder 724 selects 512 word-lines according to the configuration of 9 row address (RA<0:8>) signals but example embodiments are not limited thereto. According to some example embodiments, the row decoder 724 may select a various number of word lines. For example, according to the signal configuration of 10 row address (RA<0:9>) or 11 row address (RA<0:10>), the row decoder 724 may select 1024 or 2048 word lines WL.

The row decoder 724 may include a main word line driver circuit 610 and sub-word line driver circuits 620. The main word line driver circuit 610 may include first and second main word line driving signal generation circuits 611 and 612 and first and second sub-word line driving signal generation circuits 613 and 614. The main word line driver circuit 610 may generate first and second main word line driving signals (NWEIB0<0:7>, NWEIB1<0:7>) based on signals of the Most Significant Bit (MSB) group among row address (RA<0:8>) signals. Among the row address (RA<0:8>) signals, the MSB group signals may be set to an RA<3:8> row address. The RA<3:8> row address may be divided into an upper bit group RA<6:8> row address (hereinafter referred to as "RA678") and a lower bit group RA<3:5> row address (hereinafter referred to as "RA345").

In some example embodiments, the first main word line driving signal generation circuit 611 may generate a first main word line driving signal (NWEIB0<0:7>) according to decoding the RA678 row address, and the second main word line driving signal generation circuit 612 may generate a second main word line driving signal (NWEIB1<0:7>) according to decoding the RA345 row address. In an example, the main word line driver circuit 610 according to an example embodiment divides the MSB signals (RA<3:8>) of the row address (RA<0:8>) signals into 2 groups (e.g., RA678 and RA345), and based on the division, eight of each of the first and second main word line driving signals (NWEIB0<0:7> and NWEIB1<0:7>) are generated. In other example embodiments, the main word line driver circuit 610 may change decoding for generating a plurality of main word line driving signals (NWEIBn-1, n is a natural number) based on the number of bits (e.g., 5, 6, and 7) of the MSB group signals of the row address signals according to the configuration of various number of word lines (e.g., 1024 or 2048).

The second main word line driving signal generation circuit 612 may be configured of eight units that each output a second main word line driving signal (NWEIB1<0:7>) in response to the decoded RA345<0:7> row address signal. The decoded RA345<0:7> row address signal configuration includes eight cases (e.g., 000, 001, 010, 011, 100, 101, 110, and 111), so the activated second main word line driving signal (NWEIB1< 0:7>) may also be 8. That is, according to the decoded RA345<0:7> row address signal, any one signal of NWEIB1<0>, NWEIB1<1>, NWEIB1<2>, NWEIB1<3>, NWEIB1<4>, NWEIB1<5>, NWEIB1<6>, and NWEIB1<7> may be activated to a logic low level. The second main word line driving signal (NWEIB1<0:7>) at a logic low level has a ground voltage (VSS) level and may be provided to the sub-word line driver circuit 620 connected to each of the memory blocks (BLK1 to BLKi).

The main word line driver circuit 610 may generate first and second sub-word line driving signals (PXID<0:7>, PXIB<0:7>) based on signals of the Least Significant Bit (LSB) group among the row address (RA<0:8>) signals. Among the row address (RA<0:8>) signals, the LSB group signals may be set to RA<0:2> row address (hereinafter referred to as "RA012"). The main word line driver circuit 610 may include first sub-word line driving signal generating circuit 613 that generates a first sub-word line driving signal (PXID<0:7>) according to decoding the RA012 row address and a second sub-word line driving signal generation circuit 614 that generates a second sub-word line driving signal (PXIB<0:7>) according to decoding the RA012 row address.

Although it is described that the main word line driver circuit 610 according to an example embodiment generates eight of each of the first and second sub-word line driving signals (PXID<0:7>, PXIB<0:7>) based on the LSB signals (RA<0:2>) of the row address (RA<0:8>) signals, but this is only an example to facilitate understanding and is not intended to limit the inventive concepts.

The first sub-word line driving signal generation circuit 613 may be configured of eight units that each output a first sub-word line driving signal (PXID<0:7>) in response to the decoded RA012<0:7> row address signal. The decoded RA012<0:7> row address signal configuration has eight cases (e.g., 000, 001, 010, 011, 100, 101, 110, and 111), so the first sub-word line driving signal (PXID< 0:7>) may also be 8 types. That is, according to the decoded RA012<0:7> row address signal, any one signal of PXID<0>, PIXD<1>, PIXD<2>, PXID<3>, PIXD<4>, PIXD<5>, PXID<6>, and PXID<7> may be activated to a logic high level. The first sub-word line driving signal (PXID<0:7>) at a logic high level has a high voltage (VPP) level and may be provided to the sub-word line driver circuit 620 connected to each of the memory blocks (BLK1 to BLKi).

The second sub-word line driving signal generation circuit 614 may be configured of eight units that each output a second sub-word line driving signal (PXIB<0:7>) in response to the decoded RA012<0:7> row address signal. The decoded RA012<0:7> row address signal has 8 cases (e.g., 000, 001, 010, 011, 100, 101, 110, and 111), so the activated second sub-word line driving signal (PXIB<0 :7>) may also be 8 types. That is, according to the decoded RA012<0:7> row address signal, any one signal of PXIB<0>, PIXB<1>, PIXB<2>, PXIB<3>, PIXB<4>, PIXB<5>, PXIB<6>, and PXIB<7> may be activated to a logic low level. The second sub-word line driving signal (PXIB<0:7>) at a logic low level has a ground voltage (VSS) level and may be provided to the sub-word line driver circuit 620 connected to each of the memory blocks (BLK1 to BLKi).

The sub-word line driver circuit 620 may include a first sub-word line driver SWD(A) and a second sub-word line driver SWD(B). For example, the first sub-word line driver SWD(A) and the second sub-word line driver SWD(B) may be arranged alternately in one direction.

Each of the plurality of word lines WL<0:511> may be electrically connected to a plurality of sub-word line drivers SWD located in the plurality of pad regions WPR. Each of the plurality of word lines WL<0:511> may be connected to the first sub-memory cell group SMC(A) and the second sub-memory cell group SMC(B) located in the stacked region STR. The first sub-word line driver SWD(A) may be connected to the word line WL through one pad region WPR, and the second sub-word line driver SWD(B) may be connected to the word line WL through another pad region WPR. The word line WL selected by the first sub-word line driver SWD(A) among the plurality of word lines WL<0:511> may select the first sub-memory cell group SMC(A), and the word line WL selected by the second sub-word line driver SWD(B) may select the second sub-memory cell group SMC(B). That is, one word line (WL) may be connected to at least one pair of sub-word line driver circuits 620 including the first sub-word line driver SWD(A) and the second sub-word line driver SWD(B), and the first sub-memory cell group SMC(A) connected to one word line WL may be selected by the first sub-word line driver SWD(A) and the second sub-memory cell group SMC(B) may be selected by the second sub-word line driver SWD(B).

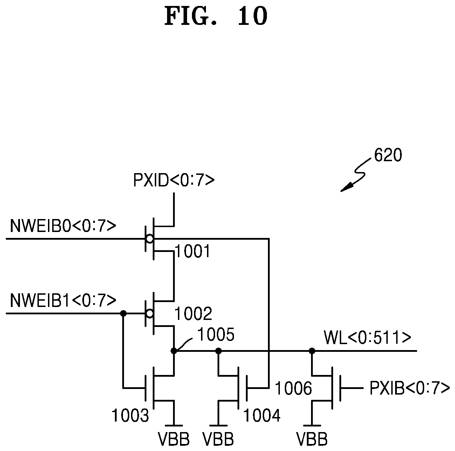

FIG. 10 is a circuit diagram for explaining the sub-word line driver circuit 620 of FIG. 9.

Referring to FIG. 10, the sub-word line driver circuit 620 may include first to fifth transistors 1001, 1002, 1003, 1004, and 1006. The first and second transistors 1001 and 1002 may be connected in series between the first sub-word line driving signal PXID<0:7> line and a connection node 1005 of the second to fourth transistors 1002 to 1004, a first main word line driving signal NWEIB0<0:7> may be connected to a gate of the first transistor 1001, and a second main word line driving signal NWEIB1<0:7> may be connected to a gate of the second transistor 1002. The third and fourth transistors 1003 and 1004 may be connected in parallel between a connection node 1005 of the second to fourth transistors 1002 to 1004 and a negative voltage VBB line, the second main word line driving signal (NWEIB1<0:7>) may be connected to a gate of the third transistor 1003, and the first main word line driving signal NWEIB0<0:7> may be connected to a gate of the fourth transistor 1004. The fifth transistor 1006 may be configured as an NMOS transistor in which a negative voltage VBB line is connected to a source, a connection node 1005 of the second to fourth transistors 1002 to 1004 is connected to a drain, and a second sub-word line driving signal (PXIB<0:7>) is applied to a gate of the second transistor 1002 and a gate of the third transistor 1003. The connection node 1005 of the second to fourth transistors 1002 to 1004 may be connected to a plurality of word lines WL<0:511> of the memory blocks BLK1 to BLKi. The first to fourth transistors 1001 to 1004 of the sub-word line driver circuit 620 may be implemented as a NOR logic circuit.

The sub-word line driver circuit 620 may be configured of 512 units connected to corresponding ones of a plurality of word lines WL<0:511> corresponding to a first main word line driving signal NWEIB0<0:7>, a second main word line driving signal NWEIB1<0:7>, a first sub-word line driving signal PXID<0:7>, and a second sub-word line driving signal PXIB<0:7>. The sub-word line driver circuit 620 may select one of a plurality of word lines WL<0:511> in response to a logic low level of the activated first main word line driving signal NWEIB0<0:7>, a logic low level of the activated second main word line driving signal NWEIB1<0:7>, a logic high level of the activated first sub-word line driving signal PXID<0:7>, and a logic low level of the activated second sub-word line driving signal PXIB<0:8> and may activate the selected word line to a logic high level. The word line WL selected from among the plurality of word lines WL<0:511> may be activated to a high voltage level of the first sub-word line driving signal PXID<0:7> of a logic high level.

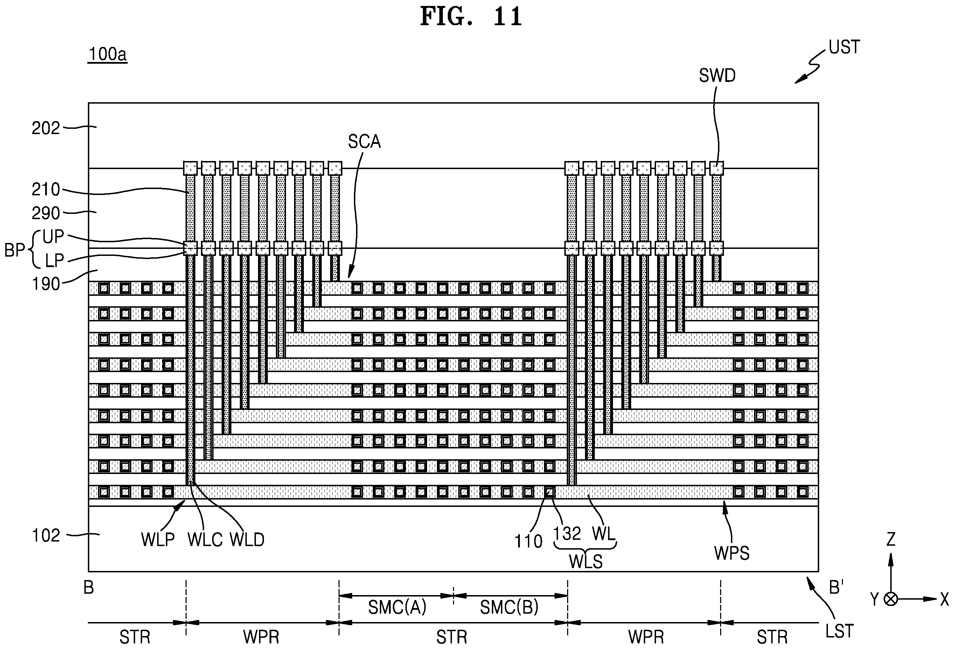

FIGS. 11 to 13 are cross-sectional views showing a portion of a semiconductor memory device 100b according to some example embodiments. Specifically, each of FIGS. 11 to 13 is a cross-sectional view taken along line B-B' of FIG. 3.

Referring to FIG. 11, the semiconductor memory device 100a includes a lower structure LST and an upper structure UST stacked on the lower structure LST. The lower structure LST has a plurality of stacked regions STR and a plurality of pad regions WPR. The lower structure LST includes a substrate 102, a sub-cell array SCA disposed in the stacked region STR, and a pad structure WPS disposed in the pad region WPR on the substrate 102. The sub-cell array SCA may include a substrate 102, a plurality of word lines WL disposed on the substrate 102 and spaced apart from the substrate 102, a plurality of bit lines BL extending in the vertical direction (Z direction) from the substrate 102, a plurality of cell transistors CT disposed between the plurality of word lines WL and the plurality of bit lines BL, and a plurality of information storage elements SP connected to the plurality of cell transistors CT. A cell transistor CT and an information storage element SP may constitute a memory cell MC.

Each of the plurality of word lines WL may include at least one word line pad WLP. A word line contact WLC may be connected to the word line pad WLP.

If word line contacts WLC are connected to corresponding ones of the word lines WL included in one sub-cell array SCA in one pad region WPR, extension lengths of the word line contacts WLC disposed in one pad region WPR in the vertical direction (Z direction) may be different from each other. The extension lengths of the word line contacts WLC disposed in one pad region WPR in the vertical direction (Z direction) may be sequentially decreased in the first horizontal direction (X direction). For example, in an X-Z plane, lower ends of word line contacts WLC disposed in one pad region WPR may be disposed in a diagonal direction with respect to the first horizontal direction (X direction) and the vertical direction (Z direction).

Lower ends of the word line contacts WLC disposed on each of a pair of pad regions WPR located at both ends of one stacked region STR in the first horizontal direction (X direction) may be disposed in the same diagonal direction with respect to the first horizontal direction (X direction) and the vertical direction (Z direction).

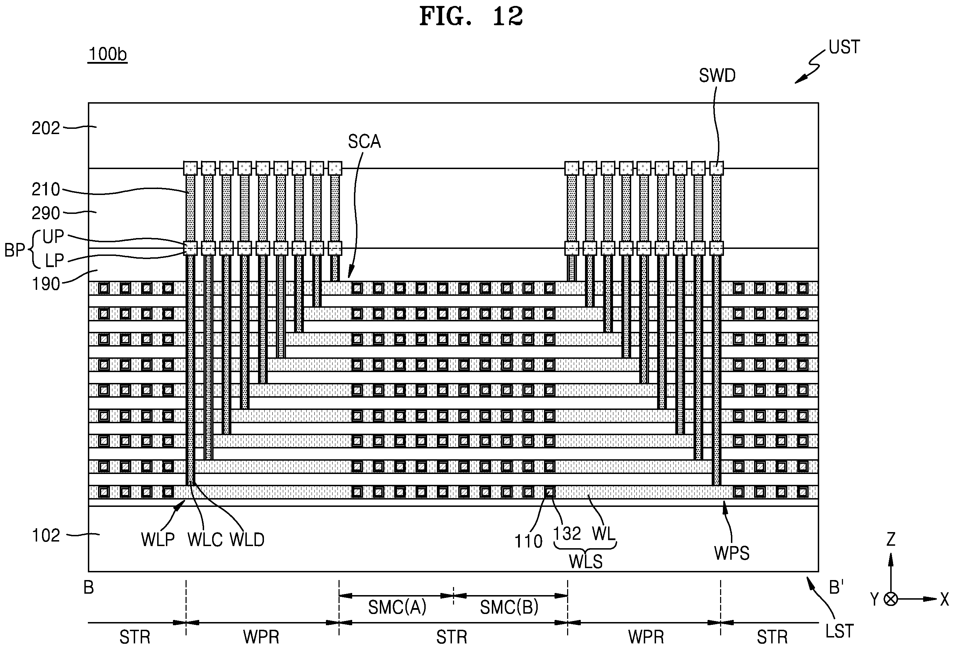

Referring to FIG. 12, the semiconductor memory device 100b includes a lower structure LST and an upper structure UST stacked on the lower structure LST. The lower structure (LST) includes a plurality of stacked regions STR and a plurality of pad regions WPR. The lower structure LST includes a substrate 102, a sub-cell array SCA disposed in the stacked region STR, and a pad structure WPS disposed in the pad region WPR on the substrate 102. The sub-cell array SCA may include a substrate 102, a plurality of word lines WL disposed on the substrate 102 and spaced apart from the substrate 102, a plurality of bit lines BL extending in the vertical direction (Z direction) from the substrate 102, a plurality of cell transistors CT disposed between the plurality of word lines WL and the plurality of bit lines BL, and a plurality of information storage elements SP connected to the plurality of cell transistors CT. A cell transistor CT and an information storage element SP may constitute a memory cell MC.

Each of the plurality of word lines WL may include at least one word line pad WLP. A word line contact WLC may be connected to the word line pad WLP.

If word line contacts WLC are connected to corresponding ones of the word lines WL included in one sub-cell array SCA in one pad region WPR, extension lengths of the word line contacts WLC disposed in one pad region WPR in the vertical direction (Z direction) may be different from each other. The extension length of the word line contacts WLC disposed in one pad region WPR in the vertical direction (Z direction) may be sequentially decreased in the first horizontal direction (X direction). For example, in an X-Z plane, lower ends of the word line contacts WLC disposed in one pad region WPR may be disposed in a diagonal direction with respect to the first horizontal direction (X direction) and the vertical direction (Z direction).

Lower ends of the word line contacts WLC disposed in one pad regions WPR among a pair of pad regions WPR located at both ends of one stacked region STR in the first horizontal direction (X direction) and lower ends of the word line contacts WLC disposed in another pad region WPR may be disposed in mirror symmetry with respect to the stacked region STR between the pair of pad regions WPR.

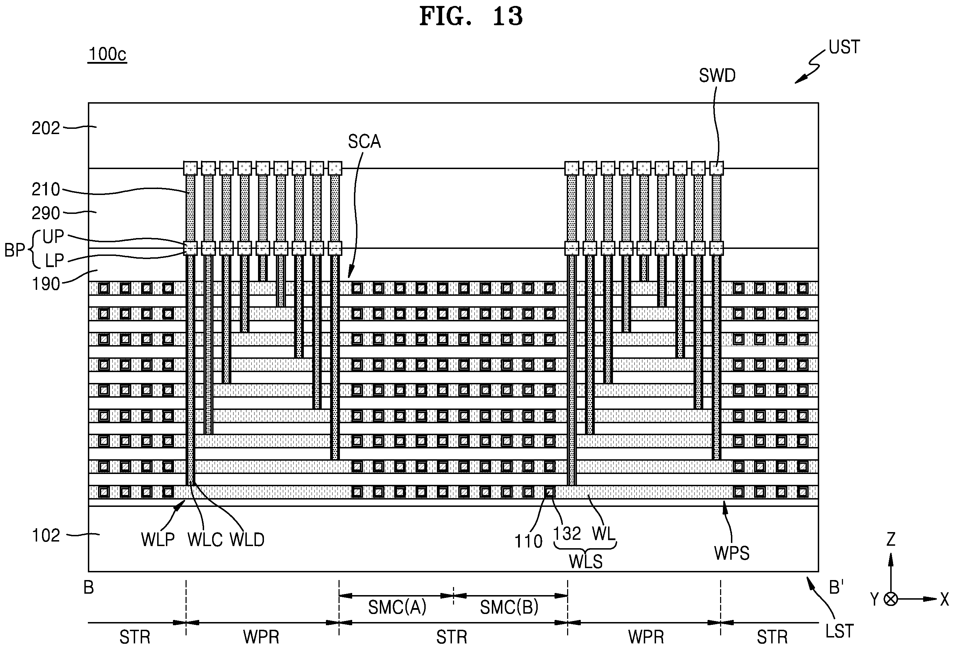

Referring to FIG. 13, the semiconductor memory device 100c includes a lower structure LST and an upper structure UST stacked on the lower structure LST. The lower structure (LST) includes a plurality of stacked regions STR and a plurality of pad regions WPR. The lower structure LST includes a substrate 102, a sub-cell array SCA disposed in the stacked region STR, and a pad structure WPS disposed in the pad region WPR on the substrate 102. The sub-cell array SCA may include a substrate 102, a plurality of word lines WL disposed on the substrate 102 and spaced apart from the substrate 102, a plurality of bit lines BL extending in the vertical direction (Z direction) from the substrate 102, a plurality of cell transistors CT disposed between the plurality of word lines WL and the plurality of bit lines BL, and a plurality of information storage elements SP connected to the plurality of cell transistors CT. A cell transistor CT and an information storage element SP may constitute a memory cell MC.

Each of the plurality of word lines WL may include at least one word line pad WLP. A word line contact WLC may be connected to the word line pad WLP.

If word line contacts WLC are connected to corresponding ones of the word lines WL included in one sub-cell array SCA in one pad region WPR, extension lengths of the word line contacts WLC disposed in one pad region WPR in the vertical direction (Z direction) may be different from each other. Among the word line contacts WLC disposed in one pad region WPR, an extension length in the vertical direction (Z direction) of a word line contact WLC located relatively far from a pair of stacked regions STR adjacent in the first horizontal direction (X direction) may be shorter than an extension length in the vertical direction (Z direction) of a word line contact WLC located relatively close to the pair of stacked regions STR. For example, in an X-Z plane, a lower end of each of the word line contacts WLC arranged in one pad region WPR may be arranged in a 180-degree reversed V-shape.

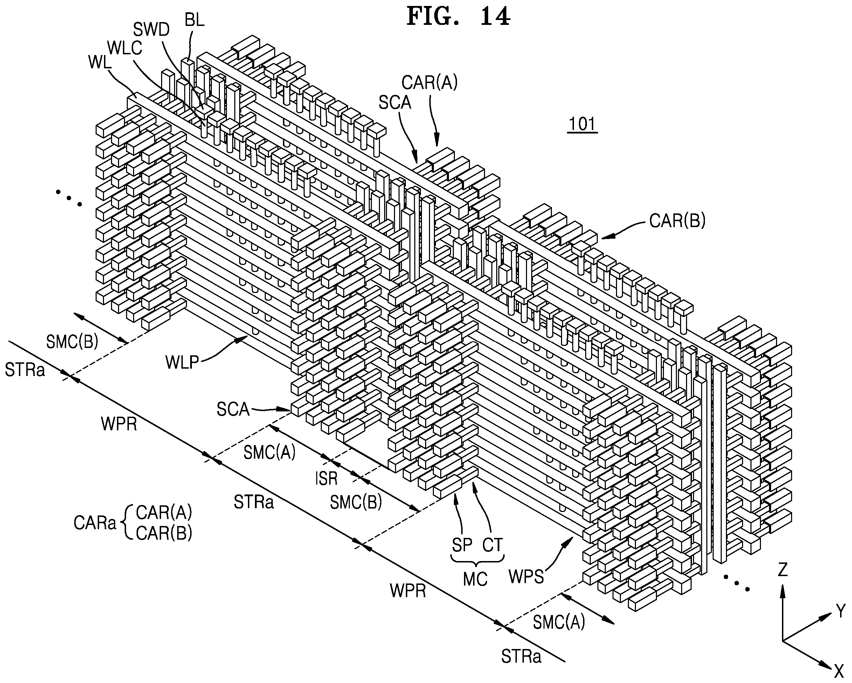

FIG. 14 is a perspective view showing a semiconductor memory device 101 according to an example embodiment.

Referring to FIG. 14, the semiconductor memory device 101 includes a plurality of stacked regions STRa and a plurality of pad regions WPR. A first stacked cell array structure CAR(A) and a second stacked cell array structure CAR(B) spaced apart in the first horizontal direction (X direction) may be disposed in each of the plurality of stacked regions STRa. Memory cells MC included in the first stacked cell array structure CAR(A) may constitute a first sub-memory cell group SMC(A), and memory cells MC included in the second stacked cell array structure CAR(B) may constitute a second sub-memory cell group SMC(B). Each of the plurality of stacked regions STRa may include an isolation insulating region ISR between the first stacked cell array structure CAR(A) and the second stacked cell array structure CAR(B). The first stacked cell array structure CAR(A) and the second stacked cell array structure CAR(B) may be spaced apart from each other with the isolation insulating region ISR therebetween.

Each of the first stacked cell array structure CAR(A) and the second stacked cell array structure CAR(B) may include a plurality of sub-cell arrays SCA. The sub-cell array SCA may include a plurality of bit lines BL, a plurality of word lines WL, and a plurality of memory cells MC. Each of the plurality of memory cells MC includes a cell transistor CT and an information storage element SP.

The plurality of word lines WL may extend in the first horizontal direction (X direction). Each of the plurality of word lines WL may extend across the stack region STRa and the pad region WPR in the first horizontal direction (X direction). Each of the plurality of word lines WL may extend from the first stacked cell array structure CAR (A) located in one stacked region STRa among a pair of adjacent stacked regions STRa in the first horizontal direction (X direction) to the second stacked cell array structure CAR(B) located in another stacked region STRa among the pair of adjacent stacked regions STRa through the pad region WPR disposed between the pair of adjacent stacked regions STRa.

A word line contact WLC may be connected to the word line pad WLP. The word line contact WLC may be in contact with the electrically connected word line WL among the word lines WL spaced apart in the vertical direction (Z direction) and may pass through the word lines WL located above the electrically connected word line WL. The word line contact WLC may not be electrically connected to the word line WL through which the word line contact WLC passes. The word line pad WLP may be connected to a sub-word line driver SWD through the word line contact WLC.

A word line WL connected to the first sub-memory cell group SMC(A) and a word line WL connected to the second sub-memory cell group SMC(B) located in one stacked region STRa may be spaced apart from each other, and the memory cells MC included in the first sub-memory cell group SMC(A) and the memory cells MC included in the second sub-memory cell group SMC(B) located in one stacked region STRa may be selected by different sub-word line drivers SWD.

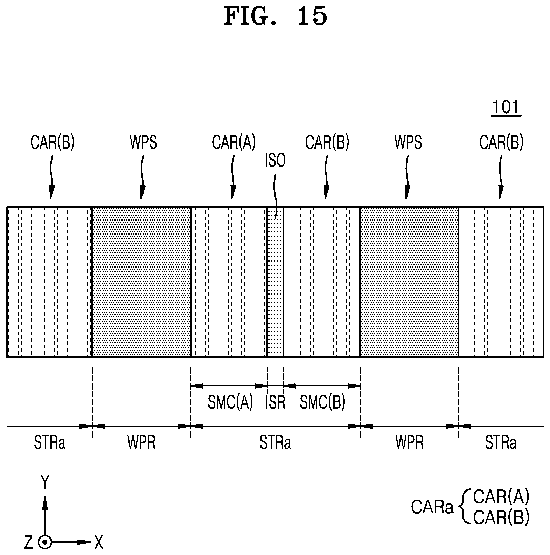

FIG. 15 is a plan layout view showing a semiconductor memory device 101 according to an example embodiment.

Referring to FIG. 15, the semiconductor memory device 101 includes a plurality of stacked regions STRa and a plurality of pad regions WPR. A first stacked cell array structure CAR(A) and a second stacked cell array structure CAR(B) spaced apart in the first horizontal direction (X direction) may be disposed in each of the plurality of stacked regions STRa, and a pad structure WPS may be located in each pad region WPR. The plurality of stacked regions STRa and the plurality of pad regions WPR may be alternately arranged in the first horizontal direction (X direction). The plurality of stacked regions STRa may be arranged to be spaced apart from each other in the first horizontal direction (X direction), and the plurality of pad regions WPR may be arranged to be spaced apart from each other in the first horizontal direction (X direction). For example, the pad region WPR may be disposed between a pair of stacked regions STRa adjacent in the first horizontal direction (X direction), and the stacked region STRa may be disposed between a pair of pad regions WPR adj acent to each other in the first horizontal direction (X direction).

The first stacked cell array structure CAR(A) may include a first sub-memory cell group SMC(A), and the second stacked cell array structure CAR(B) may include a second sub-memory cell group SMC(B). Each of the plurality of stacked regions STRa may include an isolation insulating region ISR between the first stacked cell array structure CAR(A) and the second stacked cell array structure CAR(B). The first stacked cell array structure CAR(A) and the second stacked cell array structure CAR(B) may be spaced apart from each other with the isolation insulating region ISR therebetween. An isolation insulating structure ISO may be disposed in the isolation insulating region ISR. The first stacked cell array structure CAR(A) and the second stacked cell array structure CAR(B) may be spaced apart and insulated from each other by the isolation insulating structure ISO.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

## Claims

1. A semiconductor memory device (100) comprising:
a substrate (102) including a first stacked region (STR), a second stacked region (STR), and a pad region (WPR), the pad region (WPR) being between the first stacked region (STR) and the second stacked region (STR) in a first horizontal direction (X);
a plurality of word lines (WL) extending from the pad region (WPR) toward each of the first stacked region (STR) and the second stacked region (STR) in the first horizontal direction (X), the plurality of word lines (WL) spaced apart from each other in a vertical direction (Z);
a plurality of bit lines (BL) extending in the vertical direction (Z), the plurality of bit lines (BL) spaced apart from each other in the first horizontal direction (X) in each of the first stacked region (STR) and the second stacked region (STR);
a plurality of memory cells (MC) interposed between the plurality of word lines (WL) and the plurality of bit lines (BL) in each of the first and second stacked regions (STR);
a word line contact (WLC) connected to a corresponding one of the plurality of word lines (WL) at the pad region (WPR); and
a sub-word line driver (SWD) connected to the word line contact (WLC).

2. The semiconductor memory device (100) of claim 1, wherein
a portion of a specific word line of the plurality of word lines (WL) in the first stacked region (STR) and a portion of the specific word line in the second stacked region (STR) are electrically connected to the sub-word line driver (SWD) through the word line contact (WLC) that is connected to a portion of the specific word line in the pad region (WPR).

3. The semiconductor memory device (100) of claim 1 or 2, wherein
each of the plurality of memory cells (MC) includes a cell transistor (CT) and an information storage element (SP),
the cell transistor (CT) includes a semiconductor pattern (110) extending from a corresponding one of the plurality of bit lines (BL) in a second horizontal direction (Y) different from the first horizontal direction (X),
the semiconductor pattern (110) includes a source region (SD1) connected to the corresponding one of the plurality of bit lines (BL), a channel region (CH), and a drain region (SD2) connected to the information storage element (SP), the source region (SD1), the channel region (CH), and the drain region (SD2) being sequential from the corresponding one of the plurality of bit lines (BL) in the second horizontal direction (Y).

4. The semiconductor memory device (100) of claim 3, wherein
the semiconductor pattern (110) passes through each of the plurality of word lines (WL), and
the channel region (CH) is a portion of the semiconductor pattern (110) that passes through each of the plurality of word lines (WL).

5. The semiconductor memory device (100) of any one of claims 1 to 4, wherein
a first group (SMC(A)) (SMC(A)) of memory cells (MC) adjacent to the pad region (WPR), from among the plurality of memory cells (MC) in the first stacked region (STR), and a second group (SMC(B)) (SMC(B)) of memory cells (MC) adjacent to the pad region (WPR), from among the plurality of memory cells (MC) in the second stacked region (STR), are configured to be selected by the sub-word line driver (SWD).

6. The semiconductor memory device (100) of any one of claims 1 to 5, wherein
each of the plurality of word lines (WL) extends in the first horizontal direction (X) through the pad region (WPR) from the first stacked region (STR) to the second stacked region (STR).

7. The semiconductor memory device (100) of claim 6, wherein
an extension length of each of the plurality of word lines (WL) in the first horizontal direction (X) is same.

8. The semiconductor memory device (100) of any one of claims 1 to 7, wherein the word line contact (WLC) contacts an electrically connected word line among the plurality of word lines (WL) spaced apart from each other in the vertical direction (Z), does not contact the other word lines among the plurality of word lines (WL), and passes through one or more word lines (WL) being above the electrically connected word line among the plurality of word lines (WL).

9. A semiconductor memory device (100) comprising:
a lower structure (LST); and
an upper structure (UST) stacked on the lower structure (LST), the upper structure (UST) including a sub-word line driver (SWD),
wherein the lower structure (LST) includes
a substrate (102) including a plurality of stacked regions (STR) and a plurality of pad regions (WPR), the plurality of stacked regions (STR) and the plurality of pad regions (WPR) being alternate in a first horizontal direction (X), the plurality of stacked regions (STR) including a first stacked region (STR) and a second stacked region (STR) on both sides of one pad region (WPR) of the plurality of pad regions (WPR) in the first horizontal direction (X),
a plurality of word lines (WL) each extending in the first horizontal direction (X) from one of the plurality of pad regions (WPR) toward each of the first stacked region (STR) and the second stacked region (STR), the plurality of word lines (WL) spaced apart from each other in a vertical direction (Z),
a plurality of bit lines (BL) extending in the vertical direction (Z), the plurality of bit lines (BL) spaced apart from each other in the first horizontal direction (X) in each of the plurality of stacked regions (STR),
a plurality of memory cells (MC) interposed between the plurality of word lines (WL) and the plurality of bit lines (BL) in each of the plurality of stacked regions (STR), and
a word line contact (WLC) connected to a corresponding one of the plurality of word lines (WL) in a corresponding one of the plurality of pad regions (WPR),
wherein a portion of a specific word line of the plurality of word lines (WL) in the first stacked region (STR) and a portion of the specific word line in the second stacked region (STR) are electrically connected to the sub-word line driver (SWD) through the word line contact (WLC) that is connected to a portion of the specific word line in a corresponding one of the plurality of pad regions (WPR).

10. The semiconductor memory device (100) of claim 9, wherein
the lower structure (LST) includes a first insulating structure (190) covering the plurality of word lines (WL), the plurality of bit lines (BL), the plurality of memory cells (MC), and the word line contact (WLC) on the substrate (102), and
the upper structure (UST) includes a second insulating structure (290) covering a peripheral circuit board (202), and an interconnector structure (210) connecting the sub-word line driver (SWD) to the word line contact (WLC), the second insulating structure (290) being below the peripheral circuit board (202) and surrounding the interconnector structure (210), the second insulating structure (290) contacting the first insulating structure (190).

11. The semiconductor memory device (100) of claim 10, further comprising:
a bonding pad (BP) connecting the word line contact (WLC) to the interconnector structure (210),
wherein a lower part of the bonding pad (BP) is surrounded by the first insulating structure (190), and an upper part of the bonding pad (BP) is surrounded by the second insulating structure (290).

12. The semiconductor memory device (100) of any one of claims 9 to 11, wherein each of the plurality of memory cells (MC) includes a cell transistor (CT) and an information storage element (SP),
the cell transistor (CT) includes a semiconductor pattern (110) including a source region (SD1), a channel region (CH), and a drain region (SD2), the source region (SD1), the channel region (CH), and the drain region (SD2) being sequential from a corresponding one of the plurality of bit lines (BL) in a second horizontal direction (Y) different from the first horizontal direction (X), and
the source region (SD1) is connected to a corresponding one of the plurality of bit lines (BL), the drain region (SD2) is connected to the information storage element (SP), and the channel region (CH) is surrounded by a corresponding one of the plurality of word lines (WL).

13. The semiconductor memory device (100) of any one of claims 9 to 12, wherein the plurality of stacked regions (STR) include a first stacked region (STR) and a second stacked region (STR), and
the sub-word line driver (SWD) is configured to select a first group (SMC(A)) (SMC(A)) of memory cells (MC) adjacent to the one pad region (WPR), from among the plurality of memory cells (MC) in the first stacked region (STR) and a second group (SMC(B)) (SMC(B)) of memory cells (MC) adjacent to the one pad region (WPR), from among the plurality of memory cells (MC) in the second stacked region (STR).

14. The semiconductor memory device (100) of any one of claims 9 to 13, wherein
each of the plurality of word lines (WL) extends by a same extension length in the first horizontal direction (X) through the plurality of stacked regions (STR) and the plurality of pad regions (WPR) that are alternately arranged in the first horizontal direction (X).
